(19) Europäisches Patentamt
European Patent Office
Office européen des brevets

(11) Publication number: **0 302 827 B1**

(12) **EUROPEAN PATENT SPECIFICATION**

(45) Date of publication of patent specification: **06.07.94**

(51) Int. Cl.⁵: **G03F 7/16**

(21) Application number: **88810518.6**

(22) Date of filing: **27.07.88**

# (54) Process for the formation of images.

(30) Priority: **05.08.87 GB 8718497**
**25.05.88 GB 8812385**

(43) Date of publication of application:
**08.02.89 Bulletin 89/06**

(45) Publication of the grant of the patent:
**06.07.94 Bulletin 94/27**

(84) Designated Contracting States:
**BE CH DE FR GB IT LI NL SE**

(56) References cited:
**EP-A- 0 176 356**
**EP-A- 0 177 453**
**EP-A- 0 204 415**

(73) Proprietor: **CIBA-GEIGY AG**
**Klybeckstrasse 141**
**CH-4002 Basel(CH)**

(72) Inventor: **Irving, Edward**
**41, Swaffham Road**
**Burwell Cambridge CB5 0AN(GB)**
Inventor: **Walshe, Josphine Mary Angela**
**15, Cherry Bounds Road**
**Girton Cambridge CB3 0JT(GB)**
Inventor: **Mallaband, Anne, Dr.**
**10 Grosvenor House**
**Stortford Hall Park**
**Bishops Stortford Hertfordshire CM23 5AG(GB)**

(74) Representative: **Sharman, Thomas et al**
**CIBA-GEIGY PLC.**
**Patent Department,**
**Central Research,**
**Hulley Road**
**Macclesfield, Cheshire SK10 2NX (GB)**

**EP 0 302 827 B1**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to a process for producing images and compositions suitable for use in this process.

Conventionally, images are produced on substrates by coating the substrate with a negative photoresist comprising a photopolymerisable material, irradiating the coating with actinic radiation through a negative, so that the parts of the coating struck by the radiation become photopolymerised and less soluble, whilst those parts shielded from the radiation remain substantially unaffected, then dissolving away the unirradiated, non-photopolymerised parts of the coating by means of a suitable solvent that does not dissolve the photopolymerised parts. This last stage is known as development. Where the surface of the substrate coated with the photoresist is metallic, the surface exposed on development may be etched to form a printing plate or printed circuit. The photopolymerised coating may then be removed, either chemically by means of a solvent, or mechanically by means of brushes etc., or, more usually, by a combination of both methods.

Both liquids and dry film negative photoresists have been used in conventional image-forming processes. The liquid photoresists are usually solutions of film-forming photopolymerisable materials in organic solvents, which have to be evaporated in the formation of a photoresist film on a substrate. Apart from the environmental problems associated with such use of organic solvents, it is difficult, using these liquid resists, to form uniform photoresist films which are free from pinholes. When used in the production of printed circuit boards with metal-plated through-holes or vias, blocking of the holes and poor coating of the edges of the holes are common problems. In order to avoid the disadvantages of liquid photoresists, dry film photoresists have been used. These, however, have poor adhesion to metal surfaces unless the metal is subjected to a special pretreatment, and cannot be used successfully on irregular surfaces. The use of dry film photoresists also entails cutting of the film to the dimensions of the surface to be coated, giving rise to a considerable amount of waste film.

The problems encountered in using conventional liquid and dry film photoresists can be avoided by electrodepositing a suitable photoresist on an electrically conductive surface. United States Patent 4 592 816, for example, proposes the electrodeposition of a photoresist film from an aqueous solution or emulsion containing a mixture of a positively or negatively charged polymer, a multifunctional acrylate or methacrylate as photocrosslinking monomer and a photoinitiator. While use of an electrodeposition bath containing such a mixture can initially give satisfactory images, after a small number of electrodepositions have been carried out the elecrodeposited film does not form a satisfactory image, even on exposure to radiation for considerably longer than the initially deposited film.

It has now been found that images suitable for use in printed circuits and printing plates can be formed with good reproducibility from photoresist films obtained by electrodeposition from an electrodeposition medium containing a multifunctional photopolymerizable material and a polymer having in the same molecule a photopolymerisation-initiating residue for the photopolymerizable groups and a salt or salt-forming group.

Accordingly, the present invention provides a process for the formation of an image on a substrate having an electrically conductive surface which comprises

(i) applying a photopolymerizable film to said surface by electrodeposition from a composition comprising a solution or dispersion in an electrodeposition medium of a mixture of (A) a photopolymerizable material having, per average molecule, more than one photopolymerizable ethylenically unsaturated group, and (B) a film-forming polymer having in the same molecule a photoinitiating residue which initiates polymerization of said photopolymerizable group on exposure to radiation and a salt-forming group which is present at least partially in ionised form, said polymer being substantially free from ethylenic unsaturation,

(ii) subjecting the film to radiation in a predetermined pattern thereby polymerizing exposed areas of the film, and

(iii) removing areas of the film not exposed in stage (ii).

Photoinitiating residues which initiate polymerization of photopolymerizable unsaturated groups are well known. These residues produce free radicals either by photolytic dissociation or by a reaction, usually hydrogen transfer, with another molecule. Thus suitable photoinitiating residues include benzophenone, ketocoumarin, benzil, anthraquinone, phenanthraquinone, alpha-substituted acetophenone, acylphosphine oxide, O-acylated alpha-oximinoketone, xanthone or thioxanthone residues connected to the remainder of the resin molecule through one or more linkages. Amongst these, benzophenone, alpha-substituted acetophenone and thioxanthone residues are preferred. The alpha-substituted acetophenone residues are usually acetophenone residues substituted on the alpha carbon atom by a hydroxyl, alkoxy, hydroxyalkyl,

alkoxyalkyl or tertiary amino group. The benzophenone residues may be in the backbone of the polymer (B), being linked to the remainder of the molecule through 2 to 4 linkages, or attached to the backbone of the polymer. The substituted acetophenone and thioxanthone residues are preferably attached to the backbone.

Suitable polymers (B) include vinyl polymers having said photoinitiating residue and said salt-forming group. Thus suitable polymers can be obtained by modification of a polymer of a styrene to introduce the photoinitiating residue and salt-forming group. For example, the benzene rings of a polymer of a styrene can be acylated by a Friedel-Crafts reaction with an alpha-substituted carboxylic acid halide to form alpha-substituted acetophenone residues attached to the polymer backbone, these residues reacted further to introduce salt-forming groups.

Preferred vinyl polymers are copolymers of (B1) a vinyl compound having said photoinitiating residue with (B2) an ethylenically unsaturated monomer containing an acidic or basic group, and optionally, (B3) at least one other ethylenically unsaturated monomer. Examples of vinyl compounds (B1) having said photoinitiating residue are acrylate and methacrylate esters of hydroxyl-substituted benzophenones and of hydroxyalkyleneoxy-, e.g 2-hydroxyethyleneoxy-, substituted benzophenones. Other such vinyl compounds are adducts of hydroxyl- or carboxyl-substituted benzophenones with glycidyl acrylate, glycidyl methacrylate, or isocyanatoalkyl acrylates or methacrylates. Preferred such vinyl compounds are those having an alpha-substituted acetophenone photoinitiating residues. Thus preferred copolymers are those of (B1) a vinyl compound having an alpha-substituted acetophenone photoinitiating residue with (B2) an ethylenically unsaturated monomer containing an acidic or basic group and, optionally, (B3) at least one other ethylenically unsaturated monomer.

The vinyl compound (B1) having an alpha-substituted acetophenone residue is usually an acrylic compound, preferably an alpha-substituted acetophenone having an acrylic ester group. Such acrylic compounds can be reaction products of hydroxyl- or carboxyl-containing alpha-substituted acetophenones with a glycidyl or isocyanatoalkyl ester of an acrylic acid, such as acrylic acid, methacrylic acid or a carboxyl group-containing adduct of a hydroxyalkyl acrylate or methacrylate with a polycarboxylic acid anhydride. Other such acrylic compounds can be esters of hydroxyl-containing alpha-substituted acetophenones with an acrylic acid such as those mentioned above or an esterifying derivative thereof such as the acid halide. Further such acrylic compounds can be esters of carboxyl-containing alpha-substituted acetophenones, or esterifying derivatives thereof, with a hydroxyalkyl ester of an acrylic acid such as those mentioned above.

Preferred acrylic compounds from which the copolymers may be derived are those of formula

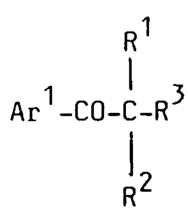

I

where

$R^1$ denotes a monovalent aliphatic group of 1 to 10 carbon atoms, preferably an alkyl of alkoxy group,

$R^2$ denotes an alkyl group of 1 to 10 carbon atoms or a group of formula II, III or IIIA

$-X-O-R^4-OCOC(R^5)=CH_2$ II

$-X-NH-R^6-OCOC(R^5)=CH_2$ III

$-CH_2[OCH_2CH(OH)CH_2]_aOCOC(R^5)=CH_2$ IIIA

or $R^1$ and $R^2$, together with the carbon atom to which they are attached, denote a cycloalkyl group of 4 to 8 carbon atoms,

$R^3$ denotes a monovalent aromatic group of 6 to 20 carbon atoms linked through an aromatic carbon atom to the indicated carbon atom, a hydroxyl group, a tertiary amine group linked through the amino nitrogen atom to the indicated carbon atom, or a group of formula VI or VIA

$-OCOC(R^5)=CH_2$ VI

$-OCH_2CH(OH)CH_2OCOC(R^5)=CH_2$ VIA

$R^4$ denotes an alkylene group of 1 to 8, preferably 1 to 4, carbon atoms, which is unsubstituted or substituted by a hydroxyl group or by an acyloxy group of 2 to 20 carbon atoms,

$R^5$ denotes a hydrogen atom or an alkyl group of 1 to 4 carbon atoms,

$R^6$ denotes an alkylene group of 1 to 8, preferably 1 to 4, carbon atoms,

X denotes a group of formula IV or V

$-R^7CO-$ IV

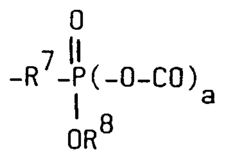

V

$R^7$ denotes an alkylene group of 1 to 8, preferably 1 to 4, carbon atoms,

$R^8$ denotes an alkyl group of 1 to 12, preferably 1 to 4, carbon atoms,

a denotes zero or 1, and

$Ar^1$ denotes a monovalent aromatic group of 6 to 20 carbon atoms linked through an aromatic carbon atom to the indicated carbonyl group,

with the provisos that

(i) $R^2$, $R^3$ or $Ar^1$ contains a group of formula

$-OCOC(R^5)=CH_2$ VI

(ii) when $R^1$ and $R^2$, together with the carbon atom to which they are attached, denote a cycloalkyl group, $R^3$ denotes a hydroxyl group, said tertiary amine group or a group of formula VI or VIA,

(iii) when $R^2$ denotes a group of formula II, a denotes zero,

(iv) when $R^2$ denotes a group of formula III, a denotes 1, and

(v) when $R^2$ denotes a group of formula IIIA , $R^3$ denotes said monovalent aromatic group of 6 to 20 carbon atoms.

In formula I, $R^1$ may be, for example, a methyl group, a methoxy group, a pentyl group or an octyloxy group. Preferably, $R^1$ denotes an alkyl group of 1 to 4 carbon atoms, which may be a methyl, ethyl, n-propyl, isopropyl, n-butyl, sec.butyl or tert.-butyl group, or an alkoxy group of 1 to 4 carbon atoms which may be a methoxy, ethoxy, n-propoxy, isopropoxy, n-butoxy, sec.butoxy or tert.butoxy group. Particularly preferred groups $R^1$ are methyl, methoxy and ethoxy groups.

When $R^2$ denotes an alkyl group, it may be, for example, a methyl group, a hexyl group or octyl group, preferably an alkyl group of 1 to 4 carbon atoms which may be a methyl, ethyl, n-propyl, isopropyl, n-butyl, sec.butyl or tert.butyl group. Where $R^2$ denotes a group of formula II or III, $R^4$ in formula II may be an ethylene, propylene, butylene or octylene group or a propylene or butylene group substituted by a hydroxyl group or by an acetoxy, propionyloxy, hexanoyloxy, octanoyloxy, dodecanoyloxy, hexahydrobenzoyloxy or benzoyloxy group, $R^6$ in formula III may be an ethylene, propylene, butylene or octylene group and X may be a group of formula IV or V where $R^7$ may be a methylene, ethylene, propylene, butylene or octylene group and where $R^8$ may be methyl, ethyl, propyl, butyl, hexyl, octyl, decyl or dodecyl group.

Preferably, $R^2$ denotes a group of formula IIIA, an alkyl group of 1 to 4 carbon atoms or a group of formula II or III where $R^4$ denotes a group of formula

$-CH_2CH(OH)CH_2-$ VII

$R^6$ denotes an ethylene or propylene group and X denotes a group of formula IV or V where $R^7$ denotes an ethylene or propylene group and $R^8$ denotes a methyl or ethyl group. In particular preferred embodiments, $R^2$ denotes a methyl or ethyl group or a group of formula II or III where $R^6$ and $R^7$ each denote an ethylene group and $R^8$ denotes an ethyl group or a group of formula IIIA.

In embodiments where $R^1$ and $R^2$, together with the carbon atom to which they are attached, denote a cycloalkyl group, that group may be a cyclobutyl, cyclopentyl, cyclohexyl, cycloheptyl or cyclooctyl group,

that is $R^1$ and $R^2$ together may denote a propylene, butylene, pentylene, hexylene or heptylene group. Preferably, $R^1$ and $R^2$ together with the carbon atom to which they are attached denote a cyclopentyl or, particularly, a cyclohexyl group.

Where $R^3$ denotes a monovalent $C_6$-$C_{20}$ aromatic group, it may be, for example, a phenyl group, which may be unsubstituted or substituted, for instance, by a halogen atom or an alkyl or alkoxy group of 1 to 4 carbon atoms. Where $R^3$ denotes a tertiary amine group, it usually contains 2 to 12 carbon atoms. It may be a dialkylamino group, where each alkyl group contains from 1 to 6 carbon atoms and may be substituted by a hydroxyl group, for example a dimethylamino, diethylamino, or di(hydroxyethyl)amino group; or it may be a nitrogen heterocyclic group linked through a ring tertiary nitrogen atom to the indicated carbon atom in formula I, for example a pyrrolidine, piperidine, morpholine or a 4-alkylpiperazine group. Preferably, $R^3$ denotes a phenyl group, a monovalent nitrogen heterocyclic group of 4 to 5 carbon atoms linked through a ring tertiary nitrogen atom to the indicated carbon atom in formula I, or a group of formula VI or VIA. Particularly preferred groups $R^3$ are unsubstituted phenyl, N-morpholino and a group of formula VI.

$Ar^1$ may denote, for example, a phenyl group, which may be unsubstituted or substituted, for example, by an alkyl, alkoxy or alkylthio group of 1 to 4 carbon atoms, such as a methyl, ethyl, propyl, butyl, methoxy, ethoxy or methylthio group, by a halogen atom or by a group terminated by a group of formula VI. Preferably, $Ar^1$ denotes a phenyl group which is unsubstituted or is substituted by an alkyl, alkoxy or alkylthio group of 1 to 4 carbon atoms, or by a group of formula VIII or IX:

$-Y-R^{10}-(OR^{11})_m-OCOC(R^5)=CH_2$ VIII

$-Y-R^{10}OCONHR^6OCOC(R^5)-CH_2$ IX

where

$R^5$ and $R^6$ are as hereinbefore defined,

$R^{10}$ denotes an alkylene group of 1 to 4 carbon atoms,

$R^{11}$ denotes an alkylene group of 1 to 4 carbon atoms which is unsubstituted or substituted by hydroxyl group or by an acyloxy group to 2 to 20 carbon atoms,

Y denotes an oxygen or sulphur atom and

m denotes 0 or 1.

In formulae VIII and IX, $R^6$, $R^{10}$ and $R^{11}$ may each be a methylene, ethylene, propylene or butylene group; $R^{11}$ may also be a propylene or butylene group substituted by a hydroxyl group.

In particularly preferred embodiments, $Ar^1$ denotes a phenyl group which is unsubstituted or substituted by a group of formula VIII or IX where $R^6$ and $R^{10}$ each denote an ethylene group, $R^{11}$ denotes a group of formula VII:

$-CH_2CH(OH)CH_2-$ VII

and m denotes 1.

$R^5$ may denote a hydrogen atom or a methyl, ethyl, propyl or butyl group. In particularly preferred compounds, $R^5$ denotes a hydrogen atom or a methyl group, that is the group of formula VI denotes an acryloyloxy or methacryloyloxy group.

Specific especially preferred compounds of formula I where $R^5$ denotes a hydrogen atom or a methyl group include:

(a) those in which

$R^1$ denotes a methoxy group,

$R^2$ denotes a group of formula X or XI

$-CH_2CH_2CONHCH_2CH_2OCOC(R^5)=CH_2$ X

$-CH_2CH_2COOCH_2CH(OH)CH_2OCOC(R^5)=CH_2$ XI

and

$R^3$ and $Ar^1$ each denote an unsubstituted phenyl group;

(b) those in which

$R^1$ denotes a methoxy or ethoxy group,

$R^2$ denotes a group of formula

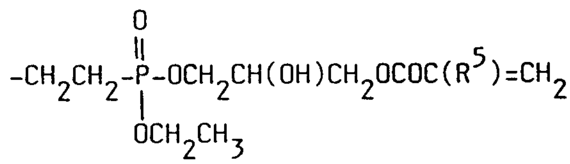
XII

and $R^3$ and $Ar^1$ each denote an unsubstituted phenyl group;

(c) those in which

$R^1$ and $R^2$ each denote a methyl group,

$R^3$ denotes a N-morpholino group and

$Ar^1$ denotes phenyl substituted by a group of formula XIII or XIV:

$-SCH_2CH_2OCONHCH_2CH_2OCOC(R)^5=CH_2$ XIII

$-SCH_2CH_2OCH_2CH(OH)CH_2OCOC(R^5)=CH_2$ XIV

(d) those in which

$R^1$ and $R^2$, together with the carbon atom to which they are attached, denote a cyclohexyl group,

$R^3$ denotes a group of formula VI:

$-OCOC(R^5)=CH_2$ IV

and $Ar^1$ denotes an unsubstituted phenyl group; and

(e) those in which

$R^1$ denotes a methoxy group,

$R^2$ denotes a group of formula

$-CH_2OCOC(R^5)=CH_2$ XIVA

and

$R^3$ and $Ar^1$ each denote an unsubstituted phenyl group.

Compounds of formula I, where $R^2$ denotes a group of formula II or III, where $R^4$ denotes a group of formula $-CH_2CH(OH)CH_2-$ and X denotes a group of formula IV, may be prepared by reacting a compound of formula

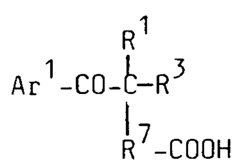
XV

with either

(i) a glycidyl ester of formula

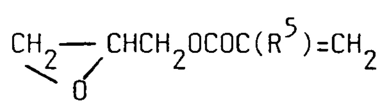
XVI

or

(ii) an isocyanatoalkyl ester of formula

$OCN-R^6-OCOC(R^5)=CH_2$ XVII

where

$R^1$ denotes an alkyl or alkoxy group of 1 to 10 carbon atoms,

$R^3$ denotes a $C_6$-$C_{20}$ aromatic group or a hydroxyl group, $R^5$, $R^6$ and $R^7$ are as hereinbefore defined and

$Ar^1$ is as hereinbefore defined and is free from ethylenic unsaturation.

The reaction between the carboxylic acid of formula XV and the glycidyl ester of formula XVI may be carried out under conventional conditions for carboxyl-epoxide reaction where one of the reactants contains polymerisable acrylic unsaturation. For instance, the carboxylic acid and the glycidyl ester may be heated together, usually in an inert organic solvent, at temperatures from 40 to 140 °C in the presence, as catalyst, of a tertiary amine, an onium salt or a chromium carboxylate. The reaction is usually carried out in the presence of a polymerisation inhibitor, for example a sterically hindered phenol such as 2,6-di-tert.butyl-p-cresol, to prevent polymerisation of the acrylic group.

Reaction between the carboxylic acid of formula XV and the isocyanatoalkyl ester of formula XVII may be effected using conventional methods for carboxyl-isocyanate reactions. For example, the carboxylic acid and the isocyanatoalkyl ester may be stirred together in an inert organic solvent at ambient temperatures in the presence of a tertiary amine as catalyst.

A process for the preparation of a compound of formula I in which $R^2$ denotes a group of formula II or III, where $R^4$ denotes a group of formula $-CH_2CH(OH)CH_2-$ and X denotes a group of formula V, comprises reacting a compound of formula

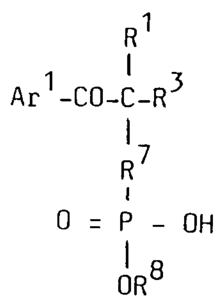

XVIII

with either a glycidyl ester of formula XVI as hereinbefore defined or an isocyanatoalkyl ester of formula XVII as hereinbefore defined where

$R^1$ denotes an alkyl or alkoxy group of 1 to 10 carbon atoms,

$R^3$, $R^7$ and $R^8$ are as hereinbefore defined and

$Ar^1$ is as hereinbefore defined and is free from ethylenic unsaturation.

The reaction between the compound of formula XVIII and the glycidyl ester may be carried out under conventional conditions for hydroxyl-epoxide reactions where one of the reactants contains a polymerisable acrylic group. For instance, the reaction may be carried out using the process hereinbefore described for the reaction of the carboxylic acid of formula XV with the glycidyl ester.

Reaction between the compound of formula XVIII and the isocyanatoalkyl ester may be effected using conventional methods for hydroxyl-isocyanate reactions, for example by heating the reactants together, at a temperature from 30 to 130 °C, in an inert solvent in the presence of a tin carboxylate salt as catalyst.

Another process for the preparation of a compound of formula I comprises reacting a compound of formula

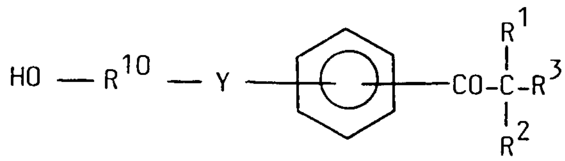

XIX

with either a glycidyl ester of formula XVI or an isocyanatoalkyl ester of formula XVII, where

$R^1$ denotes an alkyl or alkoxy group of 1 to 10 carbon atoms,

$R^2$ denotes an alkyl group of 1 to 10 carbon atoms,

or $R^1$ and $R^2$ together with the carbon atom to which they are attached denote a $C_4$ to $C_8$ cycloalkyl group,

$R^3$ is as hereinbefore defined,

$R^{10}$ denotes an alkylene group of 1 to 4 carbon atoms and

Y denotes an oxygen or sulphur atom.

The reactions between the compound of formula XIX and the glycidyl ester or isocyanatoalkyl ester may be carried out under conventional conditions for hydroxyl-epoxide or hydroxyl-isocyanate reactions respectively, for example the methods described above for reaction of the glycidyl ester or isocyanatoalkyl ester with a compound of formula XVIII.

Carboxylic acids of formula XV can be prepared by a Michael addition reaction of a compound of formula

$Ar^1$-CO-CH($R^1$)$R^3$ XX

such as a benzoin alkyl ester, with an ester of an unsaturated carboxylic of formula

$R^{12}COOH$ XXI

where $Ar^1$, $R^1$ and $R^3$ are as defined in formula XV, and $R^{12}$ denotes an alkenyl group of 2 to 4 carbon atoms, in the presence of an alkaline catalyst, followed by hydrolysis of the resulting ester.

Carboxylic acids of formula XV can also be prepared by reaction of a compound of formula XX with an aldehyde of formula

OCH-$R^{13}$-COOH XXII

where $R^{13}$ denotes an alkylene group of 1 to 3 carbon atoms, in the presence of an alkaline catalyst.

Compounds of formula XVIII can be prepared by a Michael addition reaction, in the presence of an alkaline catalyst, of a compound of formula XX, such as a benzoin alkyl ether, with an unsaturated phosphonic acid dialkyl ester of formula

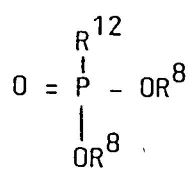

XXIII

where $R^8$ and $R^{12}$ are as hereinbefore defined, as described in United States Patent 4 082 821, followed by hydrolysis of one of the groups -$OR^8$ in the resulting ester. This hydrolysis may conveniently be effected by heating together with sodium hydroxide or potassium hydroxide in solution in ethanol or methanol.

Compounds of formula XIX where $R^1$ and $R^2$ each denote $C_1$ to $C_{10}$ alkyl, $R^3$ denotes an aromatic group and Y denotes -S-can be prepared by reacting an acid chloride of formula

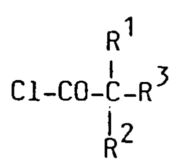

XXIV

with a halobenzene, usually chlorobenzene or bromobenzene, under conventional Friedel-Crafts reaction conditions to give an intermediate of formula

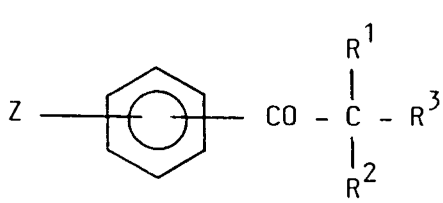

XXV

where Z denotes -Cl or -Br, and heating the intermediate with 2-mercaptoethanol in the presence of a strong base such as an alkali metal hydroxide or carbonate, usually in a polar solvent such as dimethylformamide or dimethyl sulphoxide, to replace -Z by $-SCH_2CH_2OH$.

Analogues compounds of formula XIX where Y denotes -O-can be prepared by reacting the acid chloride of formula XXIV with anisole to give an intermediate analogous to that of formula XXV, but with Z-being replaced by $CH_3O$-, reacting the intermediate with hydrobromic acid to convert the methoxy group to hydroxyl and then reacting the hydroxyl group with chloroethanol or ethylene oxide.

Compounds of formula XIX where $R^3$ denotes a hydroxyl group can be prepared by the process described in published PCT Application WO 86/05778. Compounds of formula XIX where $R^3$ denotes a tertiary amino group and Y denotes -S-, and the preparation of such compounds, are described in United States Patent 4 582 862. Analogous compounds where Y denotes -O-, and their preparation, are described in United States Patent 4 559 371.

Compounds of formula I where $R^1$ and $R^2$, together with the carbon atoms to which they are attached, denote a cycloalkyl group and $R^3$ denotes a group of formula VI can be prepared by reacting, usually under conventional conditions for hydroxyl-acid chloride reactions, a compound of formula

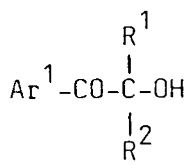

XXVI

with an acid chloride of formula

$Cl\text{-}CO\text{-}C(R^5)=CH_2$ XXVII

where

$R^1$ and $R^2$ together with the carbon atom to which they are attached denote a $C_4$ to $C_8$ cycloalkyl group,

$R^5$ denotes hydrogen or methyl and

$Ar^1$ is as hereinbefore defined and is free from ethylenic unsaturation.

Compounds of formula XXVI, such as 1-benzoylcyclopentanol or 1-benzoylcyclohexanol, can be prepared as described in United States Patent 4 308 400.

Compounds of formula I where $R^1$ and $R^2$ together with the carbon atom to which they are attached, denote a cycloalkyl group and $R^3$ denotes a group of formula VIA can be prepared by reacting a compound of formula XXVI with a glycidyl ester of formula XVI.

Compounds of formula I where $R^2$ denotes a group of formula IIIA, where a denotes zero, can be prepared by reacting a compound of formula

$Ar^1\text{-}CO\text{-}CH(R^1)R^3$ XXVIII

with formaldehyde to give a methylol compound of formula

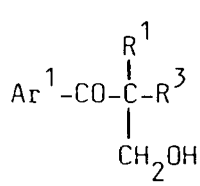

XXIX

and then reacting the methylol compound with an acid chloride of formula XXVII, where

$R^1$ and $R^3$ are as hereinbefore defined, and

$Ar^1$ is as hereinbefore defined and is free from ethylenic unsaturation.

Compounds of formula XXVIII, usually benzoin ethers, are commercially available. Tbe formation of the methylol derivative may be effected under conventional methylolating conditions and reaction of the methylol compound with the acid chloride may be carried out under conventional conditions for alcohol-acid chloride reactions.

Compounds of formula I where $R^2$ denotes a group of formula IIIA, where a denotes 1, can be prepared by reacting a methylol compound of formula XXIX with a glycidyl ester of formula XVI. Such a reaction may be carried out under conventional conditions for alcohol-epoxide reactions.

Vinyl compounds (B1) having a benzophenone photoinitiating residue can be prepared by reacting a hydroxyl group-containing benzophenone such as p-hydroxybenzophenone or p-(2-hydroxyethoxy)-benzophenonewith an acid chloride of formula XXVII. Such a reaction may be carried out under conventional conditions for hydroxyl-acid chloride reactions, usually in an inert solvent in the presence of a tertiary amine. Hydroxyalkyleneoxy-substituted benzophenones such as p-(2-hydroxyethoxy)benzophenone can be prepared by reacting the corresponding hydroxybenzophenone with an alkylene oxide such as ethylene oxide or propylene oxide or with a haloalkanol such as 2-bromoethanol.

Suitable acidic monomers (B2) include unsaturated carboxylic acids, for example monocarboxylic acids such as acrylic acids and crotonic acid and polycarboxylic acids such as maleic acid, unsaturated sulphonic acids such as vinylsulphonic acid and unsaturated phosphonic acids such as vinylphosphonic acids. Suitable basic monomers (B2) include ethylenically unsaturated materials containing a tertiary amine group, such as dialkylaminoalkyl esters of unsaturated carboxylic acids.

Preferred monomers (B2) are carboxylic acids or tertiary amines containing a group of formula

$-OCOC(R^5)=CH_2$ VI

where $R^5$ denotes a hydrogen atom or an alkyl group of 1 to 4 carbon atoms, preferably a hydrogen atom or a methyl group.

Thus preferred monomers (B2) include acrylic acid, methacrylic acid, adducts of hydroxyalkyl acrylates or methacrylates with aliphatic, cycloaliphatic or aromatic polycarboxylic acid anhydrides such as glutaric, hexahydrophthalic or phthalic anhydride, and tertiary amino-substituted alkyl esters of acrylic and methacrylic acids, particularly dialkylaminoalkyl esters of acrylic and methacrylic acids, such as dimethylaminoethyl methacrylate.

Preferred copolymers are those of (B1) the vinyl compound, particularly an acrylic compound of formula I, (B2) the monomer containing an acidic or basic group and (B3). Monomers suitable for use as (B3) include acrylic monomers, styrenes, and vinyl esters. Preferred monomers (B3) are styrene and acrylic esters of formula

$R^{14}OCOC(R^5)=CH_2$ XXX

where $R^5$ denotes a hydrogen atom or an alkyl group of 1 to 4 carbon atoms, preferably a hydrogen atom or a methyl group, and $R^{14}$ denotes an alkyl group of 1 to 10 carbon atoms, which may be substituted by a hydroxyl group. Thus preferred monomers (B3) include styrene,methyl acrylate, ethyl acrylate, 2-hydroxyethyl acrylate, n-propyl acrylate, isopropyl acrylate, 2-hydroxypropyl acrylate, n-butyl acrylate, isobutyl acrylate, hexyl acrylate, ethylhexyl acrylate, the corresponding methacrylates and mixtures of two or more of the specified monomers.

Particularly preferred monomers (B3) are styrene, methyl methacrylate, ethyl acrylate, 2-hydroxyethyl methacrylate, n-butyl methacrylate, isobutyl methacrylate, 2-ethylhexyl acrylate and mixtures of two or more thereof.

The copolymers of (B1), (B2) and (B3) may be prepared from polymerizable monomer mixtures in which the amount by weight of (B1) is generally from 1 to 50%, preferably 3 to 25%, especially 5 to 10%; the amount by weight of (B2) is generally from 1 to 50%, preferably 3 to 25%, especially 5 to 15%, and the amount by weight of (B3) is generally from 10 to 98%, preferably 50 to 95%, especially 75 to 90%.

The polymers (B) used in the process of the invention may have number average molecular weights (Mn) from 1000 to 100,000 and weight average molecular weights (Mw) from 5000 to 250,000. Preferred polymers (B) have Mn from 5000 to 50,000 and Mw from 10,000 to 200,000. Particularly preferred polymers (B) have Mn from 7000 to 30,000 and Mw from 15,000 to 70,000 and from 70,000 to 180,000.

The polymers (B) may be prepared by conventional polymerization processes using free radical polymerization initiators such as organic peroxides, hydroperoxides and azo compounds. Thus the polymerizable monomer or mixture of monomers may be heated together with the initiator in solution in an organic solvent, preferably an organic solvent which is miscible with the electrodeposition medium. Conventional chain transfer agents such as tert.dodecyl mercaptan can be used where desired.

The material (A) is usually a substance having, per average molecule, more than one vinyl group, such as divinylbenzene, preferably a substance having, per average molecule, more than one group of formula

$CH_2 = C(R^{15})COO-$ XXXI

where $R^{15}$ denotes a hydrogen, chlorine or bromine atom, or an alkyl group of 1 to 4 carbon atoms. Substances where $R^{15}$ denotes a hydrogen atom or a methyl group are particularly preferred.

Such materials are well known, including esters of a carboxylic acid containing a group of formula XXXI with polyhydric alcohols, which can be low molecular weight alcohols or film-forming resins such as hydroxyl-terminated polyethers or polyesters or polyvinyl alcohols; esters of a carboxylic acid having a group of formula XXVII with epoxide resins; and acrylic urethane reaction products of isocyanate-terminated polyurethane prepolymers with a hydroxyalkyl ester of a carboxylic acid having a group of formula XXXI.

Preferred polymerizable materials (A) are esters of a carboxylic acid having a group of formula XXXI with a polyhydric alcohol or with an epoxide resin. The carboxylic acid containing a group of formula XXXI may be acrylic acid, methacrylic acid or an adduct formed by reacting a hydroxyalkyl acrylate of hydroxyalkyl methacrylate with a polycarboxylic acid anhydride. Preferred adducts are those derived from 2-hydroxyethyl, 2-hydroxypropyl or 3-hydroxypropyl acrylate or methacrylate and saturated or unsaturated aliphatic anhydrides such as succinic, adipic, glutaric or maleic anhydride, cycloaliphatic anhydrides such as tetrahydrophthalic or hexahydrophthalic anhydride, or aromatic anhydrides such as phthalic, trimellitic or pyromellitic anhydride. Preferred esters are those of acrylic and methacrylic acids, i.e. polyacrylate and polymethacrylate esters of polyhydric alcohols and epoxide resins.

Polyhydric alcohols from which the esters may be derived include those having from 2 to 10 alcoholic hydroxyl groups. Such alcohols may be aliphatic, cycloaliphatic, heterocyclic or aromatic compounds.

Where the polyhydric alcohol is aliphatic, it may have from 2 to 6 hydroxyl groups. Suitable alcohols include diols such as alkylene glycols, for example ethylene, 1,2-propylene, trimethylene, tetramethylene, neopentylene, hexamethylene, octamethylene and dodecamethylene glycols, oxyalkylene glycols such as di(ethylene glycol) and di(propylene glycol) and adducts of the above alkylene glycols with one mol of ethylene oxide or propylene oxide, and polyoxyalkylene glycols such as polyoxyethylene glycols, for example di-, tri- and tetra-ethylene glycols, and higher polyoxyethylene glycols, polyoxypropylene glycols, for example polyoxypropylene glycols such as tri-propylene glycol, and adducts of the alkylene glycols mentioned above with more than one mol of ethylene oxide or propylene oxide. Suitable aliphatic triols include glycerol, 1,1,1-trimethylolpropane and their adducts with ethylene oxide or propylene oxide. Where the aliphatic alcohol from which the ester is derived is a tetrol, it may be erythritol, pentaerythritol, or their adducts with ethylene oxide or propylene oxide. Where the aliphatic polyhydric alcohol is pentol, it may be arabitol, xylitol or their adducts with ethylene oxide or propylene oxide. Suitable aliphatic hexols include dipentaerythritol, mannitol, sorbitol, and their adducts with ethylene oxide or propylene oxide.

Cycloaliphatic polyhydric alcohols from which the esters may be derived are usually cycloaliphatic compounds having from 2 to 6 hydroxyalkyl substituents, for instance $C_5$ to $C_8$ mononuclear cycloaliphatic compounds having two or three hydroxyalkyl substituents, preferably a di- or tri- hydroxymethyl- or hydroxyethyl-substituted cyclohexane.

Where the polyhydric alcohol from which the ester is derived is a heterocyclic alcohol, it may be a heterocyclic compound having from 2 to 6 hydroxyalkyl substituents, for instance a 5- or 6- membered heterocycle having 2 or 3 hydroxyalkyl substituents, preferably a di- or tri-hydroxymethyl- or hydroxyethyl-substituted 5- or 6-membered heterocycle such as isocyanuric acid, uracil, urazole, or uric acid, especially tris(2-hydroxyethyl) isocyanurate.

Aromatic polyhydric alcohols from which the esters can be derived are usually aromatic compounds having from 2 to 8 hydroxyalkyl substituents, including mononuclear compounds such as di- and tri-methylolphenol, and polynuclear compounds such as phenolformaldehyde resole resins, and adducts of these mononuclear and polynuclear compounds or polyhydric phenols with ethylene oxide or propylene oxide. Preferred aromatic alcohols are 1,3-dimethylolbenzene, 1,3,5-trimethylolbenzene and, particularly, 2,2-bis(p-(2-hydroxyethoxy)phenyl)propane.

The esters of polyhydric alcohols are mostly known compounds or may be made by well-known processes. They may be prepared by reacting the carboxylic acid having a group of formula XXXI, preferably acrylic or methacrylic acid or, more usually, an esterifying derivative thereof, such as acryloyl or methacryloyl chloride, with the polyhydric alcohol. Where the latter contains more than two hydroxyl groups, two hydroxyl groups may be esterified and one or more of the remaining hydroxyl groups left unesterified.

Epoxide resins from which the esters may be derived include those having at least two glycidyl groups attached to an atom or atoms of oxygen, nitrogen or sulphur, and cycloaliphatic epoxide resins in which the epoxide group is part of the ring system. The polyglycidyl compounds may be polyglycidyl esters of aliphatic, cycloaliphatic or aromatic polycarboxylic acids such as adipic, succinic, hexahydrophthalic and phthalic acids, and poly(N-glycidyl) derivatives of aromatic amines such as aniline and bis(4-aminophenyl)-methane and hydantoins such as 5,5-dimethylhydantoin. Preferred epoxide resins are polyglycidyl ethers, which may have been advanced, of polyhydric alcohols or phenols, including polyglycidyl ethers of the polyhydric alcohols mentioned above and mononuclear and polynuclear polyhydric phenols. Preferred polyglycidyl ethers are diglycidyl ethers, which may have been advanced, of dihydric alcohols and phenols, including those of the dihydric alcohols mentioned above, those of mononuclear phenols such as resorcinol, bisphenols such as bis(4-hydroxyphenyl)methane and 2,2-bis(4-hydroxyphenyl)propane and polyglycidyl ethers of phenol-aldehyde novolaks. Especially preferred polyglycidyl ethers are diglycidyl ethers, which may have been advanced, of dihydric alcohols having from 2 to 60 carbon atoms, or of bis(4-hydroxyphenyl)methane, 2,2-bis(4-hydroxyphenyl)propane or 2,2-bis(3,5-dibromo-4-hydroxyphenyl)propane, or polyglycidyl ethers of novolaks derived from phenol and formaldehyde. The esters of epoxide resins may be prepared by conventional procedures, for example by reacting the carboxylic acid having a group of formula XXXI, preferably acrylic or methacrylic acid, with the epoxide resin in the presence of a catalyst such as a tertiary amine, an onium salt or a chromium salt of a carboxylic acid.

Mixtures of two or more of the esters having a group of formula XXXI can be used as the polymerizable material (A).

The unsaturated material (A) is usually present in an amount of 5 to 150% by weight of the film-forming polymer (B). Preferably, (A) is present in an amount of 20 to 75%, especially 40 to 60%, by weight of (B).

The film-forming polymer (B) containing the salt-forming group may be neutralised, at least partially, before dissolution or dispersion in the electrodeposition medium to convert the salt-forming group, at least partially, into ionised form. Preferably, however, this neutralisation is effected by the addition of a suitable acid or base to the electrodeposition medium in which the polymer containing the salt-forming group is dissolved or dispersed. The salt-forming group is usually at least 5%, preferably 10 to 75%, for example 10 to 30% or 25 to 75%, neutralised.

Where the film-forming polymer (B) contains a basic salt-forming group, electrodeposition in step (i) is preferably effected from a solution or dispersion thereof in an aqueous medium together with an acid which at least partially neutralises the basic group. Where the film-forming polymer (B) contains an acidic salt-forming group, electrodeposition in step (i) is preferably effected from a solution or dispersion thereof in an aqueous medium together with a base which at least partially neutralises the acidic group. When the film-forming polymer (B) contains both acidic and basic groups, electrodeposition in stage (i) can be effected from a solution or dispersion thereof in an aqueous medium together with an acid or base. The aqueous medium may contain a water-miscible organic solvent to assist dissolution or dispersion of the material (A) and the polymer (B). This solvent may be, for example, the solvent in which the polymer (B) is prepared. Suitable organic solvents include ketones such as acetone, methyl ethyl ketone and methyl isobutyl ketone, alcohols such as ethanol, 2-methoxyethanol, 2-ethoxyethanol, 2-n-butoxyethanol, diethylene glycol monobutyl ether, and esters such as 2-methoxypropyl acetate and 2-ethoxyethyl acetate.

Accordingly, the present invention also provides a composition suitable for carrying out the process of the invention as hereinbefore described, which composition comprises a solution or dispersion in an aqueous solvent of a mixture of a photopolymerizable material (A) and a film-forming polymer (B) having a salt-forming group as hereinbefore described and an acid or base which at least partially neutralises the salt-forming group. Conventional additives such as dyes, pigments, fillers, plasticizers and surfactants can be included in the composition. Generally the composition has a solids content of 2 to 60%, preferably 5 to 25%, by weight.

Suitable acids for effecting neutralisation are organic an inorganic acids such as acetic, lactic, trichloroacetic, methanesulphonic, glycolic, p-toluenesulphonic, hydrochloric and sulphuric acids. Suitable bases for effecting neutralisation are organic and inorganic bases such as triethylamine, triethanolamine, pyridine, morpholine, sodium or potassium hydroxide, sodium or potassium carbonate or sodium or potassium ethoxide.

Electrodeposition of the photopolymerizable film may be carried out using conventional electrodeposition procedures for resinous materials. Voltages up to 200 volts for periods of up to 5 minutes are generally used, but the precise conditions for particular materials (A) and (B), substrates and desired thicknesses may be readily determined by those skilled in the art of electrodepositing resinous materials.

The substrate on which the photopolymerizable film is deposited may be of an electrically conductive plastics material, for example a thermoset resin containing electrically conductive particles distributed therein or, preferably it is of a metal such as copper or aluminium, either as a solid metal sheet or as a metal-clad laminate which may have metal-lined through-holes or vias.

Subjection of the electrodeposited film to radiation in a predetermined pattern may be achieved by exposure through an image-bearing transparency consisting of substantially opaque and substantially transparent areas, or by means of a computer-controlled laser beam. Electro-magnetic radiation having a

wavelength of 200-600 nm is generally used, and suitable sources include carbon arcs, mercury vapour arcs, fluorescent lamps with phosphors emitting ultra violet light, argon and xenon glow lamps, tungsten lamps, and photographic flood lamps; of these mercury vapour arcs and metal halide lamps are the most suitable. The exposure time required depends on such factors as the nature of the photopolymerizable material (A), the thickness of the electrodeposited film, the type of radiation source, and its distance from the film. Suitable exposure times can readily be found by routine experimentation.

After irradiation, areas of the film not exposed to the radiation are removed, preferably by treating the film with a solvent for the unpolymerized film, which can be an aqueous or organic solvent or a mixture thereof, as developer, leaving the exposed, polymerised areas. Suitable aqueous solvents include aqueous bases such as aqueous sodium or potassium hydroxide or carbonate or disodium hydrogen phosphate solutions for use with acid group-containing film-forming polymers (B) and aqueous acids such as aqueous acetic, lactic, glycolic or p-toluenesulphonic acid for use with basic group-containing film-forming polymers (B). Suitable organic solvents include ketones such as acetone, methyl ethyl ketone and cyclohexanone, alcohols such as ethanol, 2-ethoxyethanol and 2-n-butoxyethanol, hydrocarbons such as toluene and xylene and ethers such as tetrahydrofuran and dioxan. Further suitable solvents for use as developers are mixtures of water with an organic solvent selected from those mentioned above which is water-miscible, for example a mixture of water and 2-n-butoxyethanol.

The process of the invention is useful in the production of printing plates or printed circuits.

After exposure and development, when the substrate surface is metallic, it may be etched, either to remove metal from unexposed areas in the formation of a printed circuit, or to increase the depth of the image and hence increase its differentiation, the polymerised film in the exposed areas protecting the underlying substrate from attack. Suitable etching procedures, e.g., using ferric chloride or ammonium persulphate solutions on copper substrates, are well known. The remaining film can then, if desired, be removed by treatment with a more powerful solvent than that used for development or with a similar solvent under more severe conditions, to expose the metallic surface below.

In another post-development procedure when the surface of the substrate is metallic, it is plated with a metal such as copper, tin, lead or nickel, or an alloy of metals such as these, the polymerised film in the exposed areas is removed, for example by treatment with a solvent as described above, and the metal thereby bared is etched as hereinbefore described.

The process of the invention is useful in the preparation of buried via-hole printed circuit boards, i.e. multilayer boards made using rigid laminates which have through-hole plated via-holes that interconnect the conductive tracking on their two sides.

The invention is illustrated by the following Examples in which, unless stated otherwise, all parts and percentages are by weight.

Polymer solutions used in the Examples, and materials used in their preparation, are prepared as follows:

Preparation I

1-Oxo-2-methoxy-2-(2-carboxyethyl)-1,2-diphenylethane

Benzoin methyl ether (100 g) and ethyl acrylate (50 ml) are added to dimethyl sulphoxide (150 ml) and stirred at room temperature. Aqueous sodium hydroxide solution (4 ml of 4M NaOH) is added and the reaction mixture is stirred at room temperature for 21 hours. The resulting clear solution is poured into aqueous 10% hydrochloric acid (150 ml) to produce a white precipitate, which is washed with water until the washings are neutral in pH.

The precipitate is added to a mixture of a solution of sodium hydroxide (30 g) in water (300 ml) and methanol (200 ml). The mixture is heated at 65 °C for 13 hours then poured into aqueous 10% hydrochloric acid (200 ml), when a solid is precipitated. The solid is collected, washed with water to remove traces of hydrochloric acid and redissolved in aqueous sodium hydroxide (20 g NaOH made up to 500 ml solution by addition of water). The solution obtained is washed with dichloromethane (2 x 200 ml) and then added dropwise to aqueous 10% hydrochloric acid (200 ml). The resulting precipitate is collected, washed with water (200 ml) until the washings are only slightly acidic in pH, and dried overnight in a vacuum oven at 40 °C to give 134 g of 1-oxo-2-methoxy-2-(2-carboxyethyl)-1,2-diphenylethane as a white powder.

Prepration II

Alpha, alpha-dimethyl-alpha-N-morpholino-p-(2-hydroxyethylthio)acetophenone

This compound, also known as 1-[4-(2-hydroxyethylthio)phenyl]-2-methyl-2-morpholinopropan-1-one, is prepared as described in Example B of United States Patent 4 582 862.

Preparation III

1-Oxo-2-ethoxy-2-(2-ethylphosphonoethyl)-1,2-diphenylethane

1-Oxo-2-ethoxy-2-(2-diethylphosphonoethyl)-1,2-diphenylethane (25 g, prepared from benzoin ethyl ether and diethyl vinyl phosphonate as described in Example 3 of United States Patent 4 082 821) is dissolved in ethanol (200 ml). Sodium hydroxide (20 g) is added to the solution and the mixture is heated under reflux for 3 hours. The ethanol is removed by rotary evaporation, water is added, and the mixture is washed with diethyl ether (4 x 100 ml) to remove unreacted starting material. Concentrated hydrochloric acid is added to the aqueous mixture until the pH is zero. The resulting mixture is washed with ether, water is evaporated and the residue is recrystallised from a mixture of acetone and ether to give 12.5 g of product, a compound of formula XVIII where $R^1$ is ethoxy, $R^3$ and $Ar^1$ are each phenyl, $R^7$ is $-CH_2CH_2-$ and $R^8$ is $-CH_2CH_3$.

Preparation IV

1-Oxo-2-methoxy-2-(2-ethylphosphonoethyl)-1,2-diphenylethane

1-Oxo-2-methoxy-2-(2-diethylphosphonoethyl)-1,2-diphenylethane (100 g, prepared from benzoin methyl ether and diethyl vinyl phosphonate as described in Example 1 of United States Patent 4 082 821) is dissolved in methanol (400 ml). Sodium hydroxide (40 g) is added to the solution and the mixture is heated under reflux for 2 hours. The methanol is removed by rotary evaporation, water (300 ml) is added and the mixture is washed with diethyl ether (4 x 100 ml). The resulting aqueous mixture is cooled to 0 °C, and concentrated hydrochloric acid is added until the pH is zero, when a solid is precipitated. This is washed with water and then stirred together with acetone (300 ml), when sodium chloride remains as undissolved solid. The sodium chloride is filtered off and acetone is removed by evaporation to give a solid which is recrystallised from a mixture of acetone and ether to give 90 g of product, a compound of formula XVIII where $R^1$ is methoxy, $R^3$ and $Ar^1$ are each phenyl, $R^7$ is $-CH_2CH_2-$ and $R^8$ is $-CH_2CH_3$.

Preparation V

Acrylic Monomer I

1-Oxo-2-methoxy-2-(2-carboxyethyl)-1,2-diphenylethane (10.0 g), 2,6-di-tert.butyl-p-cresol (0.2 g) and chromium III trisoctanoate (5% solution in ligroin; 0.2 g) are dissolved in toluene (150 g) and the mixture is heated to 110 °C. Glycidyl acrylate (8.58 g) is added dropwise to the solution over 30 minutes. Heating at 110 °C is continued for 6 hours until the epoxy value of the mixture falls below 0.2 equiv/kg. The toluene is removed under reduced pressure to give 26.1 g of an oil- a compound of formula I where $R^1 = OCH_3$, $R^2 =$ a group of formula XI where $R^5 = H$, and $R^3$ and $Ar^1 =$ phenyl; $^1$HNMR (acetone-$d_6$), $\delta$ 1.8-2.8 (m-4H), 3.25(s-3H), 4.1-4.5(m-5H), 5.90-6.30 (m-3H), 7.90-8.00(m-10H); IR (liquid film) 3480, 3060, 2950, 2830, 1725, 1675, 1595, 1575, 1495, 1445, 1405, 1240, 1180, 1105, 1075, 985, 850, 810, 760, 745, 705, 645, $cm^{-1}$.

Preparation VI

Acrylic Monomer II

Alpha, alpha-dimethyl-alpha-N-morpholino-p-(2-hydroxyethylthio)acetophenone (10.0 g) and dibutyltindilaurate (0.05 g) are dissolved in dry toluene (75 ml) in a vessel previously purged with nitrogen. The mixture is heated to 70 °C and 2-isocyanatoethyl methacrylate (4.5 g) in dry toluene (25 ml) with 2,6-di-t-butyl-p-cresol (0.1 g) are added dropwise over 1 hour. The reaction mixture is then heated at 70 °C for a further 2 hours. Absence of an isocyanate band in the infra-red spectrum indicates that the reaction has

gone to completion. The toluene is removed under reduced pressure at 80 °C to give 15.6 g of an oil- a compound of formula I where $R^1$ and $R^2 = CH_3$, $R^3$ = N-morpholino and $Ar^1$ = phenyl p-substituted by a group of formula XIII where $R^5 = CH_3$, $^1$HNMR(acetone-$d_6$) 1.35(s-6H), 1.95(m-3H), 2.55(m-2H, 3.5(m-6H), 4.2(m-8H), 5.5-6.1 (m-2H), 7.95(q-4H) δ; IR (liquid film) 3350, 2950, 2850, 1715, 1667, 1582, 1525, 1450, 1383, 1360, 1320, 1295, 1258, 1160, 1120, 1090, 975, 880, 855, 825, 815, 778, 755, 735, 695, $cm^{-1}$.

Preparation VII

Acrylic Monomer III

A reaction vessel is purged with nitrogen and then charged with 1-oxo-2-methoxy-2-(2-carboxyethyl)-1,2-diphenylethane (10.0 g), N,N-dimethyl-4-aminopyridine (0.74 g) and dichloromethane (100 ml). 2-Isocyanatoethyl methacrylate (5.2 g) and dichloromethane (50 ml) are added and the mixture is stirred at room temperature for $4\frac{1}{2}$ hours under a very slow nitrogen purge. At the end of this time the isocyanate band in the infra-red spectrum of the solution has disappeared. The solution is washed with aqueous 10% hydrochloric acid (100 ml) and saturated aqueous sodium bicarbonate solution (100 ml) and dried over magnesium sulphate. The dichloromethane is removed under reduced pressure to give 12.95 g of a yellow oil- a compound of formula I where $R^1 = OCH_3$, $R^2$ = a group of formula X where $R^5 = CH_3$, and $R^3$ and $Ar^1$ = phenyl.

NMR($CDCl_3$) 1.95 (m-3H), 2.2-2.9 (m-4H), 3.25(s-3H), 3.5(t-2H), 4.2(t-2H), 5.60-6.15(m-2H), 7.35-7.95 (m-10H)δ; IR (liquid film) 3340, 3080, 2950, 2830, 1715, 1675, 1635, 1595, 1550, 1445, 1320, 1295, 1240, 1165, 1105, 1080, 1045, 850, 815, 760, 740, 700, 645 $cm^{-1}$.

Preparation VIII

Acrylic Monomer IV

1-Oxo-2-ethoxy-2-(2-ethylphosphonoethyl)-1,2-diphenylethane (10.0 g) is dissolved in toluene (100.0 g) and the solution is heated to 110 °C. Glycidyl acrylate (3.2 g), chromium III trisoctanoate (5% solution in ligroin; 0.1 g) and 2,6-di-tert.-butyl-p-cresol (0.1 g) are added. After heating for 2 hours at 110 °C, the epoxy value falls to zero. The toluene is removed under reduced pressure to give 12.4 g of an oil- a compound of formula I where $R^1 = OCH_2CH_3$, $R^2$ = a group of formula XII where $R^5$ = H, and $R^3$ and $Ar^1$ = phenyl; NMR (acetone-$d_6$) 1.0-1.4 (m-6H) 2.2-2.8 (m-4H), 3.5-4.4(m-9H), 5.95-6.35(m-3H), 7.45-8.05(m-10H) δ; IR (liquid film) 3460, 3060, 2980, 2880, 1727, 1685, 1597, 1495, 1450, 1410, 1250, 1185, 1100, 1075, 1035, 860, 812, 765, 705, 655 $cm^{-1}$.

Preparation IX

Acrylic Monomer V

1-Oxo-2-methoxy-2-(2-ethylphosphonoethyl)-1,2-diphenylethane (10.0 g) is dissolved in toluene (200 ml) and the solution is heated to 110 °C. Glycidyl acrylate (3.0 g), chromium III trisoctanoate (5% solution in ligroin; 0.2 g) and 2,6-di-t-butyl-p-cresol (0.2 g) are added. After heating for 5 hours at 110 °C, the epoxy value of the solution has dropped to zero. The toluene is removed under reduced pressure to give 9.8 g of an oil - a compound of formula I where $R^1 = OCH_3$, $R^2$ = a group of formula XII where $R^5$ = H, and $R^3$ and $Ar^1$ = phenyl; $^1$HNMR(acetone-$d_6$) 1.0-1.4(m-3H), 2.0-2.9 (m-4H), 3.30(s-3H), 3.15-4.15(m-7H), 5.95-6.33(m-3H), 7.45(m-5H), 8.05(m-5H) δ; IR (liquid film) 3460, 3065, 2960, 2840, 1730, 1680, 1600, 1580, 1495, 1450, 1410, 1220, 1050, 892, 862, 815, 765, 710, 650, $cm^{-1}$.

Preparation X - Polymer Solution PS1

2-n-Butoxyethanol (67 g) is heated to 80 °C under a nitrogen atmosphere. A mixture of methyl methacrylate (60.0 g), n-butyl methacrylate (25.5 g), 2-(dimethylamino)ethyl methacrylate (DMAEMA) (8.0 g), Acrylic Monomer I (6.5 g) and azobis(isobutyronitrile) (AIBN) (1.35 g) is added dropwise to the solvent over four hours. When monomer addition is complete, the reaction mixture is heated at 80 °C for a further 20 minutes before adding a further quantity of AIBN (0.15 g). After heating at 80 °C for a further 30 minutes, the polymer solution is allowed to cool to room temperature. The copolymer solution has a non-volatile content of 60% by weight, indicating essentially complete conversion of the monomers to polymer, and an

amine value of 0.37 eq/kg. The copolymer has a number average molecular weight of 13636 and a weight average molecular weight of 28859.

Preparation XI - Polymer Solution PS2

The procedure of Preparation X is repeated, replacing the ingredients by

| | |
|---|---|
| 2-n-butoxyethanol | 100 g |
| methyl methacrylate | 92 g |
| n-butyl methacrylate | 40 g |
| DMAEMA | 12 g |
| Acrylic Monomer II | 10 g |
| AIBN (0.77 g initially, 0.1 g on further addition) | 0.87 g |

The resulting co-polymer has an amine value of 0.48 equiv/kg, a number average molecular weight of 29,828 and a weight average molecular weight of 67,946.

Preparation XII - Polymer Solution PS3

The procedure of Preparation X is repeated, replacing the ingredients by

| | |
|---|---|
| 2-n-butoxyethanol | 67.0 g |
| methyl methacrylate | 60.0 g |
| n-butyl methacrylate | 25.5 g |
| DMAEMA | 8.0 g |
| Acrylic Monomer I | 6.5 g |
| AIBN (1.35 g initially, further 0.15 g) | 1.5 g |

The polymer obtained has an amine value of 0.33 eq/kg and a non-volatile content of 57.2%. It has a number average molecular weight of 12,340 and a weight average molecular weight of 29,693.

Preparation XIII - Polymer Solution PS4

2-n-butoxyethanol (100.0 g) is heated to 80°C under a nitrogen atmosphere. A mixture of methyl methacrylate (50.0 g), isobutyl methacrylate (25.5 g), DMAEMA (8.0 g), acrylic acid (10.0 g), Acrylic Monomer I (6.5 g) and AIBN (1.6 g) is added dropwise to the solvent over 4 hours. When monomers addition is complete, the reaction mixture is heated for a further 20 minutes at 80°C, AIBN (0.15 g) is added and then heating is continued at 80°C for a further 30 minutes. The copolymer solution obtained has a non-volatile content of 49% by weight, indicating essentially complete conversion of monomers to polymer. The copolymer has an amine value of 0.33 eq/kg, an acid value of 0.66 eq/kg, a number average molecular weight of 9060 and a weight average molecular weight of 23541.

Preparation XIV - Polymer Solution PS5

The procedure of Preparation X is repeated, replacing the inredients by

| | |
|---|---|
| 2-n-butoxyethanol | 67.0 g |
| methyl methacrylate | 60.0 g |
| n-butyl methacrylate | 25.5 g |
| DMAEMA | 8.0 g |
| Acrylic Monomer I | 6.5 g |
| AIBN (1.6 g + further 0.15 g) | 1.75 g |

The resulting copolymer solution has a solids content of 58.9% and an amine value of 0.43 equiv./kg. The copolymer has a number average molecular weight of 13,047 and a weight average molecular weight of

25,577.

Preparation XV - Polymer Solution PS6

A mixture of methyl methacrylate (60 g), n-butyl methacrylate (25.5 g), DMAEMA (8.0 g), Acrylic Monomer III (6.5 g), AIBN (2.0 g), one drop of tert.dodecylmercaptan as chain transfer agent and 2-n-butoxyethanol (67 g) is heated to 80 °C under nitrogen and maintained at 80 °C for 20 minutes. Further 2-n-butoxyethanol (33 g) is added and the heating at 80 °C is continued for $4\frac{1}{2}$ hours. More AIBN (0.1 g) is added and heating at 80 °C is continued for a further hour. The copolymer solution obtained has a solids content of 48.7% and an amine value of 0.31 equiv/kg. The copolymer has a number average molecular weight of 9093 and a weight average molecular weight of 39,617.

Preparation XVI - Polymer Solution PS7

The procedure of Preparation X is repeated, replacing the ingredients by

| | |
|---|---|
| 2-n-butoxyethanol | 67.0 g |
| methyl methacrylate | 62.0 g |
| n-butyl methacrylate | 27.5 g |
| DMAEMA | 4.0 g |
| Acrylic Monomer I | 6.5 g |
| AIBN (1.6 g + further 0,15 g) | 1.75 g |
| tert.dodecylmercaptan (chain transfer agent) | 0.05 g |

The resulting copolymer solution has an amine value of 0.20 eq/kg and a solids content of 60%.

The copolymer has a number average molecular weight of 15,612 and a weight average molecular weight of 39,933.

Preparation XVII - Polymer Solution PS8

The procedure of Preparation X is repeated, replacing the ingredients by

| | |
|---|---|
| 2-n-butoxyethanol | 100 g |
| methyl methacrylate | 100 g |
| n-butyl methacrylate | 28 g |
| DMAEMA | 12 g |
| Acrylic Monomer IV | 10 g |
| AIBN | 0.87 g |

The copolymer solution obtained has a solids content of 50.3% and an amine value of 0.47 equiv./kg. The copolymer has a number average molecular weight of 15,762 and a weight average molecular weight of 47,739.

Preparation XVIII - Polymer Solution PS9

2-n-butoxyethanol (67.0 g) is heated to 80 °C under nitrogen. A mixture of methyl methacrylate (60.0 g), n-butyl methacrylate (25.5 g), DMAEMA (8.0 g), Acrylic Monomer I (6.5 g) and AIBN (1.6 g) is added over 4 hours. The heating is continued at 80 °C for a further 20 minutes, a further quantity of AIBN (0.2 g) is added and heating at 80 °C is continued for a further 30 minutes. More AIBN (0.2 g) is added and the mixture is heated at 80 °C for 30 minutes. The resulting copolymer solution has a solids content of 55.6% and an amine value of 0.35 equiv./kg. The copolymer has a number average molecular weight of 11,873 and a weight average molecular weight of 28,495.

Preparation XIX - Polymer Solution PS10

The procedure of Preparation X is repeated, replacing the ingredients by

| | |
|---|---|
| 2-n-butoxyethanol | 100 g |
| methyl methacrylate | 100 g |
| n-butyl methacrylate | 40 g |
| DMAEMA | 12 g |
| tert.butyl perbenzoate (1.40 g + further 0.15 g) | 1.55 g |
| Acrylic Monomer V | 5.1 g |

The copolymer solution obtained has a solids content of 51.3 % and an amine value of 0.52 equiv./kg.

Preparation XX - Polymer Solution PS11

The procedure of Preparation X is repeated, replacing the ingredients by

| | |
|---|---|
| 2-n-butoxyethanol | 67.0 g |
| methyl methacrylate | 60.0 g |
| n-butyl methacrylate | 25.5 g |
| DMAEMA | 8.0 g |
| Acrylic Monomer I | 6.5 g |
| AIBN (0.9 g + 0.1 g) | 1.0 g |

The resulting copolymer solution has an amine value of 0.35 equiv./kg and a solids content of 54%. The copolymer has a number average molecular weight of 14,341 and a weight average molecular weight of 37,608.

Preparation XXI - Polymer Solution PS12

A mixture of 2-n-butoxyethanol (66.0 g) and tert.dodecylmercaptan (0.05 g) is heated to 80 °C under nitrogen. A mixture of methyl methacrylate (61.3 g), n-butyl methacrylate (24.2 g) DMAEMA (8.0 g), Acrylic Monomer I (6.5 g) and AIBN (1.8 g) is added dropwise over 4 hours. The resulting mixture is heated at 80 °C for 20 minutes, further AIBN (0.2 g) is added and the heating at 80 °C continued for a further 30 minutes. The copolymer solution obtained has a solids content of 61% and an amine value of 0.34 equiv./kg. The copolymer has a number average molecular weight of 7201 and a weight average molecular weight of 15,849.

Preparation XXII - Polymer Solution PS13

The procedure of Preparation X is repeated, replacing the ingredients by

| | |
|---|---|
| 2-n-butoxyethanol | 67.0 g |
| methyl methacrylate | 60.0 g |
| ethyl acrylate | 25.5 g |
| DMAEMA | 8.0 g |
| Acrylic Monomer I | 6.5 g |
| 2.0 g AIBN (1.8 g + further 0.2 g) | 2.0 g |

The copolymer solution obtained has an amine value of 0.37 equiv./kg and a solids content of 58%. The copolymer has a number average molecular weight of 18,481 and a weight average molecular weight of 37,764.

Preparation XXIII

Preparation of Acrylic Monomer VI

Paraformaldehyde (1.8 g, 1.2 equivs. HCHO) is added to a stirred solution of benzoin methyl ether (11.3 g, 0.05 mol) in dimethyl solution (100 ml) with potassium hydroxide (0.15 g) in ethanol (2 ml). The mixture is heated under nitrogen at 40°C for 3 hours. After cooling to room temperature and neutralising, the mixture is extracted into ethyl acetate (3 x 50 ml), washed with brine, dried over magnesium sulphate and evaporated to give a viscous oil which solidifies on cooling to yield white crystals of the methylol derivative of benzoin methyl ether (95% yield); IR (KBr disc): 3300, 1680, 1260, 1060 $cm^{-1}$
$^1H$ NMR (60 MHZ) $\delta$(ppm): 8.1-7.9 (m, 2H), 7.6-7.2 (m, 8H), 4.6-4.0 (m, 2H), 3.5 (s, 3H), 2.1 (1H)

The methylol derivative (10.25, 0.04 mol) is dissolved in dichloromethane (80 ml) and triethylamine (6.69 ml, 0.048 mol) is added. The mixture is stirred for 15 minutes at room temperature, cooled to 0°C, and acrylolyl chloride (3.9 ml, 0.048 mol) is added. The reaction mixture is stirred at 0°C for 30 minutes, then at room temperature for 1 hour. The reaction is terminated by pouring into water, the organic phase is washed in aqueous sodium bicarbonate, then brine, dried over magnesium sulphate and the solvent is evaporated. The resulting yellow oil crystallises on standing and is recrystallised from ethanol to yield white crystals - a 60% yield of a compound of formula I where $R^1$ = $OCH_3$, $R^2$ = $CH_2OCOCH=CH_2$, and $R^3$ and $Ar^1$ each denote phenyl. IR (KBr disc): 1720, 1660, 1620, 1440, 1400, 980, 920 $cm^{-1}$. $^1H$ NMR (60 MHZ) $\delta$-(ppm): 8.1-7.85 (m-2H), 7.6-7.2 (m-8H), 6.3-5.7 (m-3H), 5.3-4.6 (two d-2H), 3.4(s-3H).

Preparation XXIV - Polymer Solution PS 14

A monomer mixture of 2-hydroxyethyl methacrylate (20 parts), DMAEMA (5 parts), methacrylic acid (5 parts), 2-ethylhexyl acrylate (10 parts), styrene (55 parts) and Acrylic Monomer VI (5 parts) is dissolved together with AIBN (0.3 part) in 2-n-butoxyethanol (150 parts). The solution obtained is heated at 65°C for 20 hours, then diluted with chloroform (50 ml) and poured into hexane (3 litres). The precipitate is filtered off and dried under vacuum to give a copolymer having a number average molecular weight of 18,132, a weight average molecular weight of 59,800 and an amine value of 0.36 equiv./kg. The copolymer (40 parts) is dissolved in 2-n-butoxyethanol (60 parts).

Preparation XXV - Polymer Solution PS 15

The procedure of Preparation XXIV is repeated using a monomer mixture of 2-hydroxyethyl methacrylate (20 parts), DMAEMA (10 parts), methacrylic acid (5 parts), 2-ethylhexyl acrylate (20 parts), styrene (40 parts) and Acrylic Monomer VI (5 parts) dissolved together with 2,2′-azobis(2-methylbutyronitrile) (0.5 part) in ethyl acetate (150 parts). The resulting copolymer has a number average molecular weight of 33,103, a weight average molecular weight of 133,949 and an amine value of 0.80 equiv./kg. The copolymer (40 parts) is dissolved in 2-n-butoxyethanol (60 parts).

Preparation XXVI - Polymer Solution PS 16

The procedure of Preparation XXIV is repeated using a monomer mixture of 2-hydroxyethyl methacrylate (20 parts), DMAEMA (10 parts), methacrylic acid (5 parts), 2-ethylhexyl acrylate (20 parts), styrene (35 parts) and Acrylic Monomer VI (10 parts) dissolved together with AIBN (0.5 part) in ethyl acetate (150 parts). The resulting copolymer has a number average molecular weight of 25,374, a weight average molecular weight of 124,338 and an amine value of 0.85 g equiv./kg.

The copolymer (40 parts) is dissolved in 2-n-butoxyethanol (60 parts).

Preparation XXVI I

Preparation of Acrylic Monomer VII

1-Benzoylcyclohexanol (10.21 g, 0.05 mol) is dissolved in dichloromethane (50 ml). Triethylamine (8.36 ml, 0.06 mol) is added and the mixture is stirred for 15 minutes, then cooled by an ice bath. Acrylolyl chloride (4.87 ml, 0.06 mol) is added dropwise to the cooled mixture. The resulting mixture is stirred for 15 minutes while cooling in the ice bath, stirred for 30 minutes at room temperature and then poured into water. The organic phase is washed with aqueous sodium bicarbonate, water and brine and dried over

magnesium sulphate. Evaporation of solvent from the dried mixture leaves a viscous oil which solidifies on standing to give a white solid. This is washed with petrol and dried to give a 55% yield of a compound of formula I where $R^1$ and $R^2$ together with the attached carbon denote cyclohexyl, $R^3$ denotes a group of formula VI and $Ar^1$ denotes phenyl.

IR (KBr disc): 2920, 1720, 1675, 1625, 1580, 1450, 1400, 980, 960 $cm^{-1}$.

$^1H$ NMR (60 MHZ) $\delta$(ppm): 8.0-7.8 (m-2H), 7.5-7.2 (m-3H) 6.3-5.7 (m-3H), 2.5-1.5 (m-10H)

Preparation XXVIII - Polymer Solution PS 17

The procedure of Preparation XXIV is repeated using a monomer mixture of -hydroxyethyl methacrylate (20 parts), DMAEMA (10 parts), methacrylic acid (5 parts), 2-ethylhexyl acrylate (20 parts), styrene (35 parts) and Acrylic Monomer VII (10 parts) dissolved together with AIBN (0.5 part) in ethyl acetate (150 parts). The resulting copolymer has a number average molecular weight of 23.941, a weight average molecular weight of 74,518 and an amine value of 0.74 equiv./kg. The copolymer (40 parts) is dissolved in 2-n-butoxyethanol (60 parts).

The multifunctional acrylic materials used in the Examples are as follows:

MF1

This denotes pentaerythritol triacrylate

MF2

This is prepared by the following method:
bisphenol A diglycidyl ether (250 parts) is heated to 120°C and a mixture of acrylic acid (94.9 parts), chromium III trisoctanoate (0.16 parts; 5% solution in ligroin), and 2,6-tert.butyl p-cresol (0.5 part) is added dropwise with stirring. Heated is continued for 5 hours, by which time the epoxide content of the mixture is negligible. The product, MF2, is 2,2-bis(4-(3-acryloyloxy-2-hydroxypropoxy)phenyl)propane.

MF3

This denotes 1,1,1-trimethylolpropane triacrylate.

EXAMPLES 1-19

Electrodepositable compositions are prepared as aqueous emulsions by stirring one of Polymer Solutions PS1 to PS13 (100 parts polymer solids) together with a multifunctional acrylic material (50 parts) and lactic acid (1.8 parts, added as 2.1 parts 85% acid or 2.4 parts 75% acid) and adding deionised water slowly, while continuing to stir until the mixture is completely dispersed, to achieve a desired solids content.

The aqueous emulsion is placed in an electrodeposition bath, and a copper-clad laminate and a stainless steel sheet are immersed in the emulsion as cathode and anode respectively. An electric current is passed through the solution to deposit a photopolymerisable film on the laminate. The laminate is removed from the emulsion, washed with water and dried at 70-120°C for 10 minutes to give a tack-free solid film. The dried film is irradiated through a negative using a 5000w metal halide lamp at a distance of 75 cm. and then developed by treatment with 2-n-butoxyethanol (except in Example 17, where a 1:1 mixture by volume of 2-n-butoxyethanol and water is used).

The components of the compositions used in the Examples, the solids contents of the compositions, the voltages at which, and the time for which, the current is passed, the thickness of the dried electrodeposited film and the irradiation exposure time are indicated in the following Table. In each Example, a clear negative image is obtained.

| Ex. No. | Composition Components | Solids Content | Electrodeposition Voltage (v) | Electrodeposition Time (secs.) | Film Thickness (micrometres) | Exposure Time (secs.) |
|---|---|---|---|---|---|---|
| 1 | PS1 MF1 | 21% | 100 | 60 | 41-49 | 30 |
| 2 | PS2 MF1 | 16.4% | 100 | 30 | 15-19 | 30 |
| 3 | PS2 MF2 | 20% | 100 | 30 | 30-38 | 180 |
| 4 | PS3 MF1 | 5% | 100 | 120 | 29-30 | 30 |
| 5 | PS3 MF1 | 20% | 100 | 30 | 21-24 | 30 |
| 6 | PS5 MF3 | 20% | 120 | 180 | 45-49 | 20 |
| 7 | PS9 MF1 | 20% | 100 | 60 | 41-43 | 15 |
| 8 | PS6 MF1 | 8.6% | 10 | 60 | 17-23 | 10 |
| 9 | PS7 MF1 | 12.3% | 100 | 120 | 39-42 | 30 |
| 10 | PS6 MF1 | 12% | 30 | 30 | 41-44 | 30 |

| Ex. No. | Composition Components | Solids Content | Electrodeposition | | Film Thickness (micrometres) | Exposure Time (secs.) |
|---|---|---|---|---|---|---|
| | | | Voltage (v) | Time (secs.) | | |
| 11 | PS2 MF2 | 20% | 120 | 30 | 35-40 | 120 |
| 12 | PS12 MF1 | 25% | 150 | 30 | 28-29 | 20 |
| 13 | PS11 MF1 | 20% | 100 | 30 | 12-15 | 30 |
| 14 | PS13 MF1 | 20% | 50 | 60 | 27-29 | 30 |
| 15 | PS10 MF1 | 16.4% | 100 | 30 | 20-22 | 60 |
| 16 | PS5 MF1 | 20% | 100 | 90 | 38-39 | 30 |
| 17 | PS7 MF1 | 12.3% | 100 | 30 | 22-25 | 15 |
| 18 | PS12 MF1 | 20% | 50 | 30 | 28-31 | 30 |
| 19 | PS8 MF1 | 10% | 50 | 30 | 22-28 | 60 |

EXAMPLES 20-25

Electrodepositable compositions are prepared as aqueous emulsions by stirring one of Polymer Solutions PS 14 to PS 17 (100 parts polymer solids) together with a multifunctional acrylic material (40 parts except in Example 21 where 20 parts are used) and aqueous 75% lactic acid in an amount to effect 10-30% ionization of the amine content of the polymer and adding deionised water slowly, while continuing to stir until the mixture is completely dispersed, to achieve a desired solids content.

The aqueous emulsion is placed in an electrodeposition bath, and a copper-clad laminate and a stainless steel sheet are immersed in the emulsion as cathode and anode respectively. An electric current is passed through the solution to deposit a photopolymerisable film on the laminate. The laminate is

removed from the emulsion, washed with water and dried at 110 °C for 10 minutes to give a tack-free solid film. The dried film is irradiated through a negative using a 5000w metal halide lamp at a distance of 75 cm. and then developed by treatment with cyclohexanone.

The components of the compositions used in the Examples, the percentage ionization of the amine groups, the solids contents of the compositions, the voltages at which, and the time for which, the current is passed, the thickness of the dried electrodeposited film and the irradiation exposure time are indicated in the following Table. In each Example, a clear negative image is obtained.

| Ex. No. | Composition Components | Ionization (%) | Solids Content | Electrodeposition Voltage (v) | Electrodeposition Time (Secs.) | Film Thickness (micrometres) | Exposure Time (secs.) |
|---|---|---|---|---|---|---|---|
| 20 | PS 14<br>MF 1 | 30 | 5 | 30 | 30 | 41-48 | 30 |
| 21 | PS 15<br>MF 1 | 10 | 5 | 100 | 30 | 23-26 | 20 |
| 22 | PS 15<br>MF 3 | 20 | 10 | 30 | 30 | 44-52 | 30 |
| 23 | PS 16<br>MF 1 | 10 | 5 | 50 | 120 | 22-24 | 20 |
| 24 | PS 17<br>MF 1 | 10 | 5 | 50 | 30 | 35-43 | 30 |
| 25 | PS 17<br>MF 1 | 30 | 5 | 80 | 30 | 20-26 | 30 |

## Claims

**1.** A process for the formation of an image on a substrate having an electrically conductive surface which comprises

(i) applying a photopolymerizable film to said surface by electrodeposition from a composition comprising a solution or dispersion in an electrodeposition medium of a mixture of (A) a photopolymerizable material having, per average molecule, more than one photopolymerizable ethylenically unsaturated group, and (B) a film-forming polymer having in the same molecule a photoinitiating residue which initiates polymerization of said photopolymerizable group on exposure to radiation and a salt-forming group which is present at least partially in ionized form, said polymer being substantially free from ethylenic unsaturation,

(ii) subjecting the film to radiation in a predetermined pattern, thereby polymerizing exposed areas of the film, and

(iii) removing areas of the film not exposed in stage (ii).

**2.** A process according to claim 1, in which said photoinitiating residue is a benzophenone, ketocoumarin, benzil, anthraquinone, phenanthraquinone, alpha-substituted acetophenone, acylphosphine oxide, O-acylated alpha-oximinoketone, xanthone or thioxanthone residue connected to the remainder of the polymer molecule through one or more linkages.

**3.** A process according to claim 1 or 2, in which the polymer (B) is a vinyl polymer having said photoinitiating residue and said salt-forming group.

**4.** A process according to claim 3, in which the polymer (B) is a copolymer of (B1) a vinyl compound having an alpha-substituted acetophenone photoinitiating residue with (B2) an ethylenically unsaturated monomer containing an acidic or basic group and, optionally, (B3) at least one other ethylenically unsaturated monomer.

**5.** A process according to claim 4, in which the vinyl compound (B1) is an acrylic compound of formula

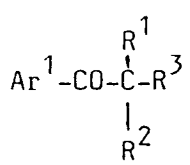

I

where

$R^1$ denotes a monovalent aliphatic group of 1 to 10 carbon atoms,

$R^2$ denotes an alkyl group of 1 to 10 carbon atoms or a group of formula II, III or IIIA

$-X-O-R^4-OCOC(R^5)=CH_2$ II

$-X-NH-R^6-OCOC(R^5)=CH_2$ III

$-CH_2[OCH_2CH(OH)CH_2]_aOCOC(R^5)=CH_2$ IIIA

or $R^1$ and $R^2$, together with the carbon atom to which they are attached, denote a cycloalkyl group of 4 to 8 carbon atoms,

$R^3$ denotes a monovalent aromatic group of 6 to 20 carbon atoms, linked through an aromatic carbon atom to the indicated carbon atom, a hydroxyl group, a tertiary amine group linked through the amino nitrogen atom to the indicated carbon atom, or a group of formula VI or VIA

$-OCOC(R^5)=CH_2$ VI

$-OCH_2CH(OH)CH_2OCOC(R^5)=CH_2$ VIA

$R^4$ denotes an alkylene group of 1 to 8 carbon atoms, which is unsubstituted or substituted by a

hydroxyl group or by an acyloxy group of 2 to 20 carbon atoms,

$R^5$ denotes a hydrogen atom or an alkyl group of 1 to 4 carbon atoms,

$R^6$ denotes an alkylene group of 1 to 8 carbon atoms,

X denotes a group of formula IV or V

$-R^7CO-$ IV

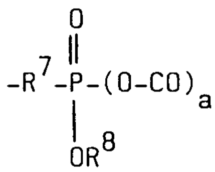

V

$R^7$ denotes an alkylene group of 1 to 8 carbon atoms,

$R^8$ denotes an alkyl group of 1 to 12 carbon atoms, a denotes zero or 1, and

$Ar^1$ denotes a movement aromatic group of 6 to 20 carbon atoms linked through an aromatic carbon atom to the indicated carbonyl group,

with the provisos that

(i) $R^2$, $R^3$ or $Ar^1$ contains a group of formula

$-OCOC(R^5)=CH_2$ VI

(ii) when $R^1$ and $R^2$, together with the carbon atom to which they are attached, denote a cycloalkyl group, $R^3$ denotes a hydroxyl group, said tertiary amine group or a group of formula VI or VIA,

(iii) when $R^2$ denotes a group of formula II, a denotes zero,

(iv) when $R^2$ denotes a group of formula III, a denotes 1, and

(v) when $R^2$ denotes a group of formula IIIA, $R^3$ denotes said monovalent aromatic group of 6 to 20 carbon atoms.

**6.** A process according to claim 5, in which $R^2$ denotes an alkyl group of 1 to 4 carbon atoms or a group of formula II or III where $R^4$ denotes a group of formula

$-CH_2CH(OH)CH_2-$ VII

$R^6$ denotes an ethylene or propylene group and X denotes a group of formula IV or V where $R^7$ denotes an ethylene or propylene group and $R^8$ denotes a methyl or ethyl group.

**7.** A process according to claim 5 or 6, in which $R^3$ denotes a phenyl group or a monovalent nitrogen heterocyclic group of 4 to 5 carbon atoms linked through a ring tertiary nitrogen atom to the indicated carbon atom.

**8.** A process according to any of claims 5 to 7, in which $Ar^1$ denotes a phenyl group which is unsubstituted or substituted by an alkyl, alkoxy or alkylthio group of 1 to 4 carbon atoms, or by a group of formula VIII or IX

$-Y-R^{10}-(OR^{11})_mOCOC(R^5)=CH_2$ VIII

$-Y-R^{10}OCONHR^6OCOC(R^5)=CH_2$ IX

where

$R^5$ and $R^6$ are as defined in claim 5,

$R^{10}$ denotes an alkylene group of 1 to 4 carbon atoms,

$R^{11}$ denotes an alkylene group of 1 to 4 carbon atoms which is unsubstituted or substituted by a hydroxyl group or by an acyloxy group of 2 to 20 carbon atoms,

Y denotes an oxygen or sulphur atom and

m denotes 0 or 1.

**9.** A process according to any of claims 5 to 8, in which $R^5$ denotes a hydrogen atom or a methyl group.

**10.** A process according to any of claims 4 to 9, in which the monomer (B2) containing an acidic or basic group is a carboxylic acid or tertiary amine containing a group of formula

$-OCOC(R^5)=CH_2$ VI

where $R^5$ represents a hydrogen atom or an alkyl group of 1 to 4 carbon atoms.

**11.** A process according to any of claims 4 to 10, in which the polymer (B) is a copolymer of (B1) the vinyl compound, (B2) the monomer containing an acidic or basic group and (B3) styrene or at least one acrylic ester of formula

$R^{14}OCOC(R^5)=CH_2$ XXX

where $R^5$ denotes a hydrogen atom or an alkyl group of 1 to 4 carbon atoms and $R^{14}$ denotes an alkyl group of 1 to 10 carbon atoms, which may be substituted by a hydroxyl group.

**12.** A process according to claim 10 or 11, in which $R^5$ denotes a hydrogen atom or a methyl group.

**13.** A process according to any of claims 1 to 12, in which (A) is a polyacrylate or polymethacrylate ester of a polyhydric alcohol or of an epoxide resin.

**14.** A process according to any of the preceding claims, in which the polymer (B) contains a basic salt-forming group and electrodeposition in step (i) is effected from a solution or dispersion thereof in an aqueous medium together with an acid which at least partially neutralizes the basic group, or the polymer (B) contains an acidic salt-forming group and electrodeposition in (i) is effected from a solution or dispersion thereof in an aqueous medium together with a base which at least partially neutralizes the acidic group.

**15.** A process according to claim 14, in which the aqueous medium contains a water-miscible organic solvent.

**16.** A composition suitable for carrying out a process according to claim 1 comprising a solution or dispersion in an aqueous solvent of a mixture of (A) a photopolymerizable material and (B) a film-forming polymer having a salt forming group, (A) and (B) being as specified in any of claims 1 to 13, and an acid or base which at least partially neutralizes the salt-forming group.

**Patentansprüche**

**1.** Verfahren zur Herstellung einer Abbildung auf einem Substrat, das eine elektrisch leitfähige Oberfläche aufweist, umfassend

(i) Auftragen eines photopolymerisierbaren Films auf die Oberfläche durch Elektroabscheidung aus einer Zusammensetzung, umfassend eine Lösung oder Dispersion in einem Elektroabscheidungsmedium aus einem Gemisch von (A) einem photopolymerisierbaren Material mit, pro durchschnittlichem Molekül, mehr als einer photopolymerisierbaren ethylenisch ungesättigten Gruppe und (B) einem filmbildenden Polymer, das im selben Molekül einen Photostart bewirkenden Rest, der Polymerisation der photopolymerisierbaren Gruppe nach Bestrahlung auslöst, und eine salzbildende Gruppe aufweist, die zumindest teilweise in ionisierter Form vorliegt, wobei das Polymer im wesentlichen frei von ethylenischer Ungesättigtheit ist,

(ii) Bestrahlen des Films in einem vorbestimmten Muster, wodurch Polymerisation der belichteten Flächen des Films bewirkt wird, und

(iii) Entfernen der in Stufe (ii) nicht belichteten Filmflächen.

**2.** Verfahren nach Anspruch 1, wobei der Photostart bewirkende Rest ein Benzophenon-, Ketocumarin-, Benzil-, Anthrachinon-, Phenanthrachinon-, $\alpha$-substituierter Acetophenon-, Acylphosphinoxid-, O-acylierter $\alpha$-Oximinoketon-, Xanthon- oder Thioxanthonrest, verbunden mit dem restlichen Polymermolekül über eine oder mehrere Bindungen, ist.

**3.** Verfahren nach Anspruch 1 oder 2, wobei das Polymer (B) ein Vinylpolymer mit dem Photostart bewirkenden Rest und der salzbildenden Gruppe ist.

**4.** Verfahren nach Anspruch 3, wobei das Polymer (B) ein Copolymer von (B1) einer Vinylverbindung, die einen Photostart bewirkenden $\alpha$-substituierten Acetophenonrest aufweist, mit (B2), einem ethylenisch ungesättigten Monomer, das eine saure oder basische Gruppe aufweist, und, gegebenenfalls (B3), mit mindestens einem anderen ethylenisch ungesättigten Monomer, ist.

**5.** Verfahren nach Anspruch 4, wobei die Vinylverbindung (B1) eine Acrylverbindung der Formel

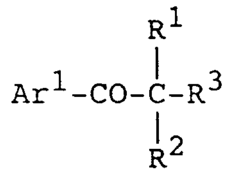

I

ist, worin $R^1$ eine einwertige aliphatische Gruppe mit 1 bis 10 Kohlenstoffatomen bedeutet,
$R^2$ eine Alkylgruppe mit 1 bis 10 Kohlenstoffatomen oder eine Gruppe der Formel II, III oder IIIA bedeutet

$-X-O-R^4-OCOC(R^5)=CH_2$ II

$-X-NH-R^6-OCOC(R^5)=CH_2$ III

$-CH_2[OCH_2CH(OH)CH_2]_aOCOC(R^5)=CH_2$ IIIA

oder $R^1$ und $R^2$, zusammen mit dem Kohlenstoffatom, an das sie gebunden sind, eine Cycloalkylgruppe mit 4 bis 8 Kohlenstoffatomen bedeuten,
$R^3$ eine einwertige aromatische Gruppe mit 6 bis 20 Kohlenstoffatomen, gebunden über ein aromatisches Kohlenstoffatom an das ausgewiesene Kohlenstoffatom, eine Hydroxylgruppe, eine tertiäre Aminogruppe, gebunden über das Aminostickstoffatom an das ausgewiesene Kohlenstoffatom, oder eine Gruppe der Formel VI oder VIA bedeutet

$-OCOC(R^5)=CH_2$ VI

$-OCH_2CH(OH)CH_2OCOC(R^5)=CH_2$ VIA

$R^4$ eine Alkylengruppe mit 1 bis 8 Kohlenstoffatomen darstellt, die unsubstituiert oder substituiert mit einer Hydroxylgruppe oder mit einer Acyloxygruppe mit 2 bis 20 Kohlenstoffatomen ist,
$R^5$ ein Wasserstoffatom oder eine Alkylgruppe mit 1 bis 4 Kohlenstoffatomen bedeutet,
$R^6$ eine Alkylengruppe mit 1 bis 8 Kohlenstoffatomen bedeutet,
X eine Gruppe der Formel IV oder V darstellt

$-R^7CO-$ IV

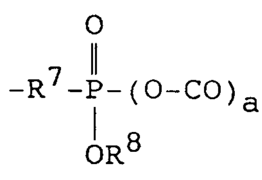

V

$R^7$ eine Alkylengruppe mit 1 bis 8 Kohlenstoffatomen bedeutet,
$R^8$ eine Alkylgruppe mit 1 bis 12 Kohlenstoffatomen bedeutet,
a Null oder 1 bedeutet, und
$Ar^1$ eine einwertige aromatische Gruppe mit 6 bis 20 Kohlenstoffatomen, gebunden über ein aromatisches Kohlenstoffatom an die ausgewiesene Carbonylgruppe, bedeutet,

mit den Maßgaben, daß
(i) $R^2$, $R^3$ oder $Ar^1$ eine Gruppe der Formel

$-OCOC(R^5)=CH_2$ VI

enthält,
(ii) wenn $R^1$ und $R^2$ zusammen mit dem Kohlenstoffatom, an das sie gebunden sind, eine Cycloalkylgruppe bedeuten, $R^3$ eine Hydroxylgruppe, die tertiäre Aminogruppe oder eine Gruppe der Formel VI oder VIA darstellt,
(iii) wenn $R^2$ eine Gruppe der Formel II bedeutet, a Null bedeutet,
(iv) wenn $R^2$ eine Gruppe der Formel III bedeutet, a 1 bedeutet, und
(v) wenn $R^2$ eine Gruppe der Formel IIIA bedeutet, $R^3$ die einwertige aromatische Gruppe mit 6 bis 20 Kohlenstoffatomen bedeutet.

**6.** Verfahren nach Anspruch 5, wobei $R^2$ eine Alkylgruppe mit 1 bis 4 Kohlenstoffatomen bedeutet oder eine Gruppe der Formel II oder III, wobei $R^4$ eine Gruppe der Formel

$-CH_2CH(OH)CH_2$ VII

bedeutet,
$R^6$ eine Ethylen- oder Propylengruppe bedeutet und X eine Gruppe der Formel IV oder V bedeutet, wobei $R^7$ eine Ethylen- oder Propylengruppe bedeutet und $R^8$ eine Methyl- oder Ethylgruppe bedeutet.

**7.** Verfahren nach Anspruch 5 oder 6, wobei $R^3$ eine Phenylgruppe oder eine einwertige stickstoffheterocyclische Gruppe mit 4 bis 5 Kohlenstoffatomen bedeutet, gebunden über ein tertiäres Stickstoffringatom an das ausgewiesene Kohlenstoffatom.

**8.** Verfahren nach einem der Ansprüche 5 bis 7, wobei $Ar^1$ eine Phenylgruppe bedeutet, die unsubstituiert oder substituiert mit einer Alkyl-, Alkoxy- oder Alkylthiogruppe mit 1 bis 4 Kohlenstoffatomen ist oder mit einer Gruppe der Formel VIII oder IX

$-Y-R^{10}-(OR^{11})_mOCOC(R^5)=CH_2$ VIII

$-Y-R^{10}OCONHR^6OCOC(R^5)=CH_2$ IX

wobei
$R^5$ und $R^6$ wie in Anspruch 5 definiert sind,
$R^{10}$ eine Alkylengruppe mit 1 bis 4 Kohlenstoffatomen bedeutet,
$R^{11}$ eine Alkylengruppe mit 1 bis 4 Kohlenstoffatomen bedeutet, die unsubstituiert oder substituiert ist mit einer Hydroxylgruppe oder mit einer Acyloxygruppe mit 2 bis 20 Kohlenstoffatomen,
Y ein Sauerstoff- oder Schwefelatom bedeutet und
m 0 oder 1 bedeutet.

**9.** Verfahren nach einem der Ansprüche 5 bis 8, wobei $R^5$ ein Wasserstoffatom oder eine Methylgruppe bedeutet.

**10.** Verfahren nach einem der Ansprüche 4 bis 9, wobei das Monomer (B2), das eine saure oder basische Gruppe enthält, eine Carbonsäure oder ein tertiäres Amin mit einer Gruppe der Formel

$-OCOC(R^5)=CH_2$ VI

darstellt, wobei $R^5$ ein Wasserstoffatom oder eine Alkylgruppe mit 1 bis 4 Kohlenstoffatomen bedeutet.

**11.** Verfahren nach einem der Ansprüche 4 bis 10, wobei das Polymer (B) ein Copolymer aus (B1) der Vinylverbindung, (B2) dem Monomer mit einer sauren oder basischen Gruppe und (B3) Styrol oder mindestens einem Acrylester der Formel

$R^{14}OCOC(R^5)=CH_2$ XXX

ist, wobei $R^5$ ein Wasserstoffatom oder eine Alkylgruppe mit 1 bis 4 Kohlenstoffatomen bedeutet und $R^{14}$ eine Alkylgruppe mit 1 bis 10 Kohlenstoffatomen bedeutet, die mit einer Hydroxylgruppe substituiert sein kann.

**12.** Verfahren nach Anspruch 10 oder 11, wobei $R^5$ ein Wasserstoffatom oder eine Methylgruppe bedeutet.

**13.** Verfahren nach einem der Ansprüche 1 bis 12, wobei (A) ein Polyacrylat- oder Polymethacrylatester eines mehrwertigen Alkohols oder Epoxidharzes ist.

**14.** Verfahren nach einem der vorangehenden Ansprüche, wobei das Polymer (B) eine basische salzbildende Gruppe enthält und Elektroabscheidung in Schritt (i) aus einer Lösung oder einer Dispersion davon in einem wässerigen Medium, zusammen mit einer Säure, die mindestens teilweise die basische Gruppe neutralisiert, bewirkt wird oder Polymer (B) eine saure salzbildende Gruppe enthält und die Elektroabscheidung in (i) aus einer Lösung und einer Dispersion davon in einem wässerigen Medium, zusammen mit einer Base, die mindestens teilweise die saure Gruppe neutralisiert, bewirkt wird.

**15.** Verfahren nach Anspruch 14, wobei das wässerige Medium ein mit Wasser mischbares organisches Lösungsmittel enthält.

**16.** Zusammensetzung, geeignet zur Ausführung eines Verfahrens nach Anspruch 1, umfassend eine Lösung oder Dispersion in einem wässerigen Lösungsmittel eines Gemisches von (A) einem photopolymerisierbaren Material und (B) einem filmbildenden polymer mit einer salzbildenden Gruppe, wobei (A) und (B) wie in einem der Ansprüche 1 bis 13 ausgewiesen sind, und eine Säure oder Base, die die salzbildende Gruppe zumindest teilweise neutralisiert.

**Revendications**

**1.** Procédé pour la formation d'une image sur un substrat ayant une surface conductrice de l'électricité, qui consiste à

(i) appliquer un film photopolymérisable à ladite surface par électrodéposition à partir d'une composition comprenant une solution ou dispersion dans un milieu d'électrodéposition d'un mélange de (A) une matière photopolymérisable ayant, en moyenne par molécule, plus d'un groupe éthyléniquement insaturé photopolymérisable, et (B) un polymère filmogène ayant, dans la même molécule, un résidu photo-initiateur qui amorce la polymérisation dudit groupe photopolymérisable par exposition à un rayonnement et un groupe salifiable qui est présent au moins partiellement sous forme ionisée, ledit polymère étant sensiblement exempt d'insaturation éthylénique,

(ii) soumettre le film à un rayonnement selon un motif prédéterminé pour polymériser ainsi les zones exposées du film, et

(iii) retirer les zones du film n'ayant pas été exposées dans l'étape (ii).

**2.** Procédé selon la revendication 1, dans lequel ledit résidu photo-initiateur est un résidu de benzophénone, cétocoumarine, benzile, anthraquinone, phénanthraquinone, acétophénone substituée en alpha, oxyde d'acylphosphine, alpha-oximinocétone O-acylée, xanthone ou thioxanthone relié au reste de la molécule du polymère par une ou plusieurs liaisons.

**3.** Procédé selon la revendication 1 ou 2, dans lequel le polymère (B) est un polymère vinylique ayant ledit résidu photo-initiateur et ledit groupe salifiable.

**4.** Procédé selon la revendication 3, dans lequel le polymère (a) est un copolymère de (B1) un composé vinylique ayant un résidu photo-initiateur d'acétophénone substituée en alpha et (B2) un monomère éthyléniquement insaturé contenant un groupe acide ou basique et, facultativement, (B3) au moins un autre monomère éthyléniquement insaturé.

**5.** Procédé selon la revendication 4, dans lequel le composé vinylique (B1) est un composé acrylique de formule

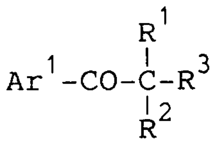

I

où

$R^1$ représente un groupe aliphatique monovalent de 1 à 10 atomes de carbone,

$R^2$ représente un groupe alkyle de 1 à 10 atomes de carbone ou un groupe de formule II, III ou IIIA

$-X-O-R^4-OCOC(R^5)=CH_2$ II

$-X-NH-R^6-OCOC(R^5)=CH_2$ III

$-CH_2[OCH_2CH(OH)CH_2]_aOCOC(R^5)=CH_2$ IIIA

ou bien $R^1$ et $R^2$, avec l'atome de carbone auquel ils sont fixés, représentent un groupe cycloalkyle de 4 à 8 atomes de carbone,

$R^3$ représente un groupe aromatique monovalent de 6 à 20 atomes de carbone lié par un atome de carbone aromatique à l'atome de carbone indiqué, un groupe hydroxyle, un groupe amino tertiaire lié par l'atome d'azote d'amine à l'atome de carbone indiqué, ou un groupe de formule VI ou VIA

$-OCOC(R^5)=CH_2$ VI

$-OCH_2CH(OH)CH_2OCOC(R^5)=CH_2$ VIA

$R^4$ représente un groupe alkylène de 1 à 8 atomes de carbone, qui est non substitué ou substitué par un groupe hydroxyle ou par un groupe acyloxy de 2 à 20 atomes de carbone,

$R^5$ représente un atome d'hydrogène ou un groupe alkyle de 1 à 4 atomes de carbone,

$R^6$ représente un groupe alkylène de 1 à 8 atomes de carbone,

X représente un groupe de formule IV ou V

$-R^7CO-$ IV

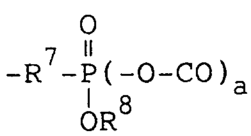

V

$R^7$ représente un groupe alkylène de 1 à 8 atomes de carbone,

$R^8$ représente un groupe alkyle de 1 à 12 atomes de carbone,

a est zéro ou 1, et

$Ar^1$ représente un groupe aromatique monovalent de 6 à 20 atomes de carbone lié par un atome de carbone aromatique au groupe carbonyle indiqué,

avec les conditions suivantes :

(i) $R^2$, $R^3$ ou $Ar^1$ contient un groupe de formule

$-OCOC(R^5)=CH_2$ VI

(ii) si $R^1$ et $R^2$, avec l'atome de carbone auquel ils sont fixés, représentent un groupe cycloalkyle, $R^3$ représente un groupe hydroxyle, ledit groupe amino tertiaire ou un groupe de formule VI ou VIA,

(iii) si $R^2$ représente un groupe de formule II, a est zéro,

(iv) si $R^2$ représente un groupe de formule III, a est 1, et

(v) si $R^2$ représente un groupe de formule IIIA, $R^3$ représente ledit groupe aromatique monovalent de 6 à 20 atomes de carbone.

6. Procédé selon la revendication 5, dans lequel $R^2$ représente un groupe alkyle de 1 à 4 atomes de carbone ou un groupe de formule II ou III où $R^4$ représente un groupe de formule

$-CH_2CH(OH)CH_2-$ VII

$R^6$ représente un groupe éthylène ou propylène et X représente un groupe de formule IV ou V où $R^7$ représente un groupe éthylène ou propylène et $R^8$ représente un groupe méthyle ou éthyle.

7. Procédé selon la revendication 5 ou 6, dans lequel $R^3$ représente un groupe phényle ou un groupe hétérocyclique azoté monovalent de 4 ou 5 atomes de carbone lié par un atome d'azote cyclique tertiaire à l'atome de carbone indiqué.

8. Procédé selon l'une quelconque des revendications 5 à 7, dans lequel $Ar^1$ représente un groupe phényle qui est non substitué ou substitué par un groupe alkyle, alcoxy ou alkylthio de 1 à 4 atomes de carbone, ou par un groupe de formule VIII ou IX :

$-Y-R^{10}-(OR^{11})_m-OCOC(R^5)=CH_2$ VIII

$-Y-R^{10}OCONHR^6OCOC(R^5)=CH_2$ IX

où

$R^5$ et $R^6$ sont tels que définis dans la revendication 5,

$R^{10}$ représente un groupe alkylène de 1 à 4 atomes de carbone,

$R^{11}$ représente un groupe alkylène de 1 à 4 atomes de carbone qui est non substitué ou substitué par un groupe hydroxyle ou par un groupe acyloxy de 2 à 20 atomes de carbone,

Y représente un atome d'oxygène ou de soufre, et

m est 0 ou 1.

9. Procédé selon l'une quelconque des revendications 5 à 8, dans lequel $R^5$ représente un atome d'hydrogène ou un groupe méthyle.

10. Procédé selon l'une quelconque des revendications 4 à 9, dans lequel le monomère (B2) contenant un groupe acide ou basique est un acide carboxylique ou une amine tertiaire contenant un groupe de formule

$-OCOC(R^5)=CH_2$ VI

où $R^5$ représente un atome d'hydrogène ou un groupe alkyle de 1 à 4 atomes de carbone.

11. Procédé selon l'une quelconque des revendications 4 à 10, dans lequel le polymère (B) est un copolymère de (B1) le composé vinylique, (B2) le monomère contenant un groupe acide ou basique et (B3) du styrène ou au moins un ester acrylique de formule

$R^{14}OCOC(R^5)=CH_2$ XXX

où $R^5$ représente un atome d'hydrogène ou un groupe alkyle de 1 à 4 atomes de carbone et $R^{14}$ représente un groupe alkyle de 1 à 10 atomes de carbone, qui peut être substitué par un groupe hydroxyle.

12. Procédé selon la revendication 10 ou 11, dans lequel $R^5$ représente un atome d'hydrogène ou un groupe méthyle.

13. Procédé selon l'une quelconque des revendications 1 à 12, dans lequel (A) est un polyacrylate ou polyméthacrylate d'un alcool polyhydrique ou d'une résine époxy.

14. Procédé selon l'une quelconque des revendications précédentes, dans lequel le polymère (B) contient un groupe salifiable basique et l'électrodéposition de l'étape (i) est effectuée à partir de sa solution ou dispersion dans un milieu aqueux auquel est associé un acide qui neutralise au moins partiellement le

groupe basique, ou le polymère (B) contient un groupe salifiable acide et l'électrodéposition de (i) est effectuée à partir de sa solution ou dispersion dans un milieu aqueux auquel est associé une base qui neutralise au moins partiellement le groupe acide.

**15.** Procédé selon la revendication 14, dans lequel le milieu aqueux contient un solvant organique miscible à l'eau.

**16.** Composition convenant pour exécuter un procédé selon la revendication 1, comprenant une solution ou dispersion, dans un solvant aqueux, d' un mélange de (A) une matière photopolymérisable et (a) un polymère filmogène ayant un groupe salifiable, (A) et (a) étant tels que spécifiés dans l'une quelconque des revendications 1 à 13, et un acide ou une base qui neutralise au moins partiellement le groupe salifiable.